# EUROPEAN PATENT APPLICATION

(11) **EP 4 715 539 A1**
(43) Date of publication of application: **25.03.2026**
(21) Application number: 25200435.3
(22) Date of filing: 05.09.2025
(51) Int. Cl.: G06F 3/041, G06F 3/044, G06F 3/046

(54) **ELECTRONIC DEVICE**

(30) Priority: 24.09.2024 KR 20240128859
(71) Applicant: Samsung Display Co., Ltd., Yongin-si, Gyeonggi-Do (KR)
(72) Inventor: KIM, Hyungbae, Yongin-si (KR); SEO, Young-Seok, Yongin-si (KR); LIM, Sanghyun, Yongin-si (KR)
(74) Representative: Marks & Clerk LLP

(57) **Abstract**

An electronic device includes a first conductive layer including a first electrode having a first mesh structure, a second conductive layer that is disposed over the first conductive layer and that includes a second electrode having a second mesh structure, a third conductive layer that is disposed over the second conductive layer and that includes a plurality of bridge patterns having a third mesh structure, and a fourth conductive layer that is disposed over the third conductive layer and that includes a plurality of patterns having a fourth mesh structure and electrically connected to the plurality of bridge patterns, in which the third conductive layer further includes a first dummy pattern disposed over the second electrode.

## Description

### BACKGROUND

### 1. Technical Field

The disclosure relates to an electronic device capable of sensing an input of a pen.

### 2. Description of the Related Art

Display devices used for displaying images have been applied to various multimedia electronic devices, such as a television, a mobile phone, a tablet computer, a notebook computer, a car navigation device, a game machine, and the like. The electronic devices may include a sensor layer (or, an input sensor) capable of providing a touch-based input method, allowing a user to intuitively and conveniently input information or instructions in a simple manner, in addition to conventional input methods such as a button, a keyboard, a mouse, or the like. The sensor layer may sense the user's touch or pressure. Electronic devices, including pens for inputting information as writing instruments or for accurate touch inputs in specific application programs (e.g., application programs for sketching or drawing), have been increasingly in demand.

It is to be understood that this background of the technology section is, in part, intended to provide useful background for understanding the technology. However, this background of the technology section may also include ideas, concepts, or recognitions that were not part of what was appreciated by those skilled in the pertinent art prior to a corresponding effective filing date of the subject matter disclosed herein.

### SUMMARY

Embodiments provide an electronic device capable of sensing an input of a pen.

However, embodiments of the disclosure are not limited to those set forth herein. The above and other embodiments will become more apparent to one of ordinary skill in the art to which the disclosure pertains by referencing the detailed description of the disclosure given below.

According to an embodiment, an electronic device includes a first conductive layer including a first electrode having a first mesh structure, a second conductive layer that is disposed over the first conductive layer and that includes a second electrode having a second mesh structure, a third conductive layer that is disposed over the second conductive layer and that includes a plurality of bridge patterns having a third mesh structure, and a fourth conductive layer that is disposed over the third conductive layer and that includes a plurality of patterns having a fourth mesh structure and electrically connected to the plurality of bridge patterns, in which the third conductive layer further includes a first dummy pattern disposed over the second electrode.

The plurality of bridge patterns and the plurality of patterns may be included in a third electrode. The fourth conductive layer may further include a fourth electrode that is electrically insulated from the third electrode and that intersects the third electrode.

The first dummy pattern may be disposed between the second electrode and the fourth electrode.

The second conductive layer may further include a second dummy pattern disposed between the first electrode and the plurality of bridge patterns.

The first conductive layer may further include a third dummy pattern. The third dummy pattern may overlap at least one of the second electrode, the plurality of bridge patterns, the plurality of patterns, and the fourth electrode in a plan view.

In case that a signal is provided to at least one of the third electrode and the fourth electrode, another signal may be provided to the first dummy pattern, the signal provided to the at least one of the third electrode and the fourth electrode and the another signal provided to the first dummy pattern may have a same phase, and the second dummy pattern and the third dummy pattern may be grounded.

In case that a signal is provided to the second electrode, another signal may be provided to each of the first dummy pattern, the second dummy pattern, and the third dummy pattern, and the signal provided to the second electrode and the another signal provided to each of the first dummy pattern, the second dummy pattern, and the third dummy pattern may have a same phase.

In case that a signal is provided to the first electrode, another signal may be provided to each of the second dummy pattern and the third dummy pattern, the signal provided to the first electrode and the another signal provided to each of the second dummy pattern and the third dummy pattern may have a same phase, and the first dummy pattern may be grounded.

The third electrode may include a plurality of first split electrodes spaced apart from one another in a first direction. The fourth electrode may include a plurality of second split electrodes spaced apart from one another in a second direction intersecting the first direction. Each of the plurality of first split electrodes may include each of the plurality of bridge patterns and each of the plurality of patterns.

The first electrode may overlap a first split electrode among the plurality of first split electrodes in a plan view. The second electrode may overlap a second split electrode among the plurality of second split electrodes in a plan view.

The second conductive layer may further include a plurality of second dummy patterns. The plurality of second dummy patterns may not overlap the second split electrode among the plurality of second split electrodes, which overlaps the second electrode, and overlap other second split electrodes among the plurality of second split electrodes in a plan view. The first conductive layer may further include a plurality of third dummy patterns. The plurality of third dummy patterns may not overlap the first split electrode among the plurality of first split electrodes, which overlaps the first electrode, and overlap other first split electrodes among the plurality of first split electrodes in a plan view.

The first mesh structure may include a first mesh line having a first width. The second mesh structure may include a second mesh line having a second width. The third mesh structure may include a third mesh line having a third width. The fourth mesh structure may include a fourth mesh line having a fourth width.

The fourth width may be greater than the third width. The third width may be greater than or equal to the second width and the first width.

The fourth width may be greater than the third width. The third width may be greater than the second width. The second width may be greater than the first width.

The electronic device may further include a sensor driver electrically connected to the third electrode, the fourth electrode, the first electrode, and the second electrode. The sensor driver may selectively operate in at least one of a first mode to sense a touch input and a second mode to sense a pen input. The sensor driver may detect coordinates of the touch input using the third electrode and the fourth electrode in the first mode. The sensor driver may detect coordinates of the pen input using the first electrode and the second electrode in the second mode.

The first electrode may include a plurality of first electrodes. The first conductive layer may further include a first loop trace line electrically connected to first ends of the plurality of first electrodes and a second loop trace line electrically connected to at least one of the plurality of first electrodes. The first loop trace line and the second loop trace line may have a solid structure without an opening.

The electronic device may further include a display layer that is disposed under the first conductive layer and displays an image in a direction toward the first conductive layer. The first conductive layer, the second conductive layer, the third conductive layer, and the fourth conductive layer may be sequentially stacked in a direction away from the display layer.

According to an embodiment, an electronic device includes a sensor layer including a plurality of sensing parts disposed in a first direction and a second direction intersecting the first direction and disposed in a sensing area. Each of the plurality of sensing parts includes a first electrode, a second electrode that is disposed over the first electrode and that intersects the first electrode, a third electrode including a plurality of bridge patterns disposed over the second electrode and a plurality of patterns disposed on a layer different from a layer on which the plurality of bridge patterns are disposed, a fourth electrode that is electrically insulated from the third electrode and intersects the third electrode, and a first dummy pattern disposed between the second electrode and the fourth electrode. The fourth electrode and the plurality of patterns are disposed on a same layer. The first dummy pattern and the plurality of bridge patterns are disposed on a same layer.

Each of the first electrode, the second electrode, the plurality of patterns, the fourth electrode, and the first dummy pattern may have a mesh structure in which an opening is defined.

According to an embodiment, an electronic device includes a display layer, a first electrode disposed over the display layer, a second electrode that is disposed over the first electrode and that intersects the first electrode, a third electrode including a plurality of bridge patterns disposed over the second electrode and a plurality of patterns disposed on a layer different from a layer on which the plurality of bridge patterns are disposed, a fourth electrode that is electrically insulated from the third electrode and intersects the third electrode, and a sensor driver electrically connected to the third electrode, the fourth electrode, the first electrode, and the second electrode. The fourth electrode and the plurality of patterns are disposed on a same layer. The sensor driver detects coordinates of a touch input using the third electrode and the fourth electrode in a first mode to sense the touch input and detects coordinates of a pen input using the first electrode and the second electrode in a second mode to sense the pen input. Each of the first electrode, the second electrode, the plurality of patterns, and the fourth electrode has a mesh structure in which an opening is defined.

At least some of the above and other features of the invention are set out in the claims.

### BRIEF DESCRIPTION OF THE DRAWINGS

The above and other aspects, features, and advantages of certain embodiments will be more apparent from the following description taken in conjunction with the accompanying drawings, in which:
FIG. 1A is a schematic front perspective view of an electronic device according to an embodiment of the disclosure;
FIG. 1B is a schematic rear perspective view of the electronic device according to an embodiment of the disclosure;
FIG. 2 is a schematic perspective view of an electronic device according to an embodiment of the disclosure;
FIG. 3 is a schematic perspective view of an electronic device according to an embodiment of the disclosure;
FIG. 4 is a schematic cross-sectional view of a display panel according to an embodiment of the disclosure;
FIG. 5 is a schematic view for explaining an operation of an electronic device according to an embodiment of the disclosure;
FIG. 6 is a schematic cross-sectional view of the display panel according to an embodiment of the disclosure;
FIG. 7A is a schematic cross-sectional view illustrating some components of a sensor layer according to an embodiment of the disclosure;
FIG. 7B is a schematic cross-sectional view illustrating some components of the sensor layer according to an embodiment of the disclosure;
FIG. 7C is a schematic cross-sectional view illustrating some components of the sensor layer according to an embodiment of the disclosure;
FIG. 8 is a schematic plan view of the sensor layer according to an embodiment of the disclosure;
FIG. 9A is a schematic plan view illustrating a first conductive layer of a sensing part according to an embodiment of the disclosure;
FIG. 9B is a schematic plan view illustrating a second conductive layer of the sensing part according to an embodiment of the disclosure;
FIG. 9C is a schematic plan view illustrating a third conductive layer of the sensing part according to an embodiment of the disclosure;
FIG. 9D is a schematic plan view illustrating a fourth conductive layer of the sensing part according to an embodiment of the disclosure;
FIG. 10A is a schematic enlarged plan view of area XX' illustrated in FIG. 9D;
FIG. 10B is a schematic enlarged plan view of area YY' illustrated in FIG. 9A;
FIG. 11 is a schematic cross-sectional view of the sensor layer according to an embodiment of the disclosure;
FIG. 12 is a schematic view illustrating a cross-sectional view of the sensor layer and an operation of a sensor driver according to an embodiment of the disclosure;
FIG. 13 is a schematic view illustrating a cross-sectional view of the sensor layer and an operation of the sensor driver according to an embodiment of the disclosure;
FIG. 14 is a schematic view illustrating a cross-sectional view of the sensor layer and an operation of the sensor driver according to an embodiment of the disclosure;
FIG. 15A is a schematic plan view illustrating a portion of a first conductive layer according to an embodiment of the disclosure;
FIG. 15B is a schematic plan view illustrating a portion of a second conductive layer according to an embodiment of the disclosure;
FIG. 16 is a schematic cross-sectional view of the sensor layer according to an embodiment of the disclosure;
FIG. 17 is a schematic plan view illustrating some components of a sensor layer according to an embodiment of the disclosure;
FIG. 18A is a schematic view illustrating some components of a sensor layer and an operation of a sensor driver according to an embodiment of the disclosure; and
FIG. 18B is a schematic view illustrating some components of the sensor layer and an operation of the sensor driver according to an embodiment of the disclosure.

### DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise defined, the illustrated embodiments are to be understood as providing features of the disclosure. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the disclosure.

When an element, such as a layer, is referred to as being "on," "connected to," or "coupled to" another element or layer, it may be directly on, connected to, or coupled to the other component or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z-axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

Although the terms "first," "second," etc. may be used herein to describe various elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof.

The terms "part" and "unit" mean a software component or a hardware component that performs a specific function. The hardware component may include, for example, a field-programmable gate array (FPGA) or an application-specific integrated circuit (ASIC). The software component may refer to executable code and/or data used by executable code in an addressable storage medium. Thus, software components may be, for example, object-oriented software components, class components, and working components, and may include processes, functions, properties, procedures, subroutines, program code segments, drivers, firmware, micro-codes, circuits, data, databases, data structures, tables, arrays or variables.

Unless otherwise defined or implied herein, all terms (including technical and scientific terms) used herein have the same meanings as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the disclosure. Further, the blocks, units, and/or modules of some embodiments may be physically combined into more complex blocks, units, and/or modules without departing from the scope of the disclosure.

The terms "about" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Hereinafter, embodiments of the disclosure are described with reference to the accompanying drawings.

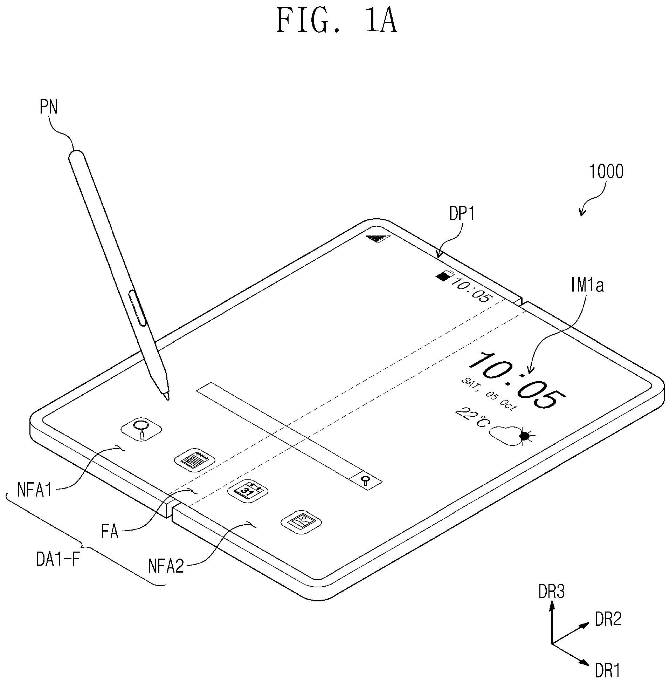

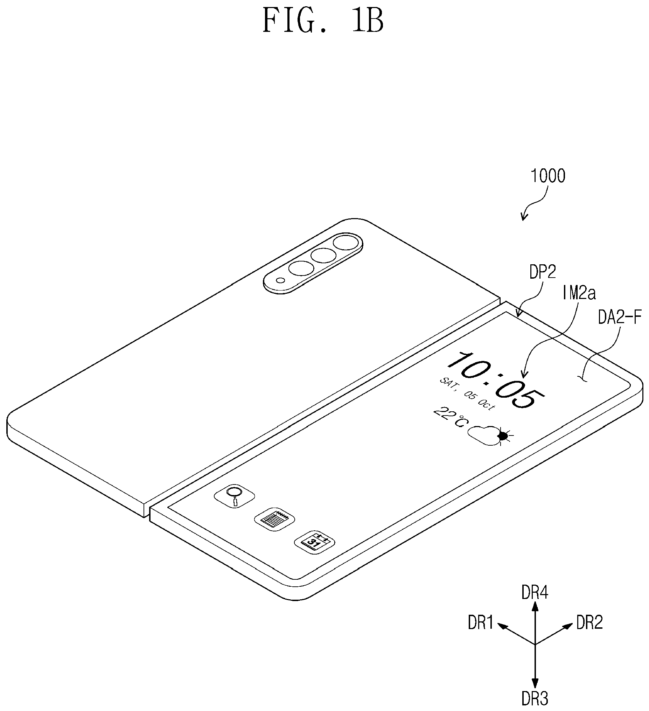

FIG. 1A is a schematic front perspective view of an electronic device 1000 according to an embodiment of the disclosure. FIG. 1B is a schematic rear perspective view of the electronic device 1000 according to an embodiment of the disclosure.

Referring to FIGS. 1A and 1B, the electronic device 1000 may be activated in response to an electrical signal. For example, the electronic device 1000 may display an image and may sense an input applied from the outside. The external input may be a user input. The user input may include various types of external inputs such as a part of a user's body, a pen PN, light, heat, pressure, or the like.

The electronic device 1000 may include a first display panel DP1 and a second display panel DP2. The first display panel DP1 and the second display panel DP2 may be separate panels spaced (or separated) from each other. The first display panel DP1 may be referred to as a main display panel, and the second display panel DP2 may be referred to as an auxiliary display panel or an external display panel.

The first display panel DP1 may include a first display part DA1-F, and the second display panel DP2 may include a second display part DA2-F. The second display panel DP2 may have a smaller area than the first display panel DP1. In correspondence to the sizes of the first display panel DP1 and the second display panel DP2, the area of the first display part DA1-F may be greater than the area of the second display part DA2-F.

In an unfolded state of the electronic device 1000, the first display part DA1-F may have a plane substantially parallel to a first direction DR1 and a second direction DR2. The thickness direction of the electronic device 1000 may be parallel to a third direction DR3 that intersects (e.g., crosses) the first direction DR1 and the second direction DR2. Accordingly, front surfaces (or, upper surfaces) and rear surfaces (or, lower surfaces) of members constituting the electronic device 1000 may be defined based on the third direction DR3.

The first display panel DP1 or the first display part DA1-F may include a folding area FA that is folded and unfolded and non-folding areas NFA1 and NFA2 spaced apart from each other with the folding area FA therebetween. For example, the folding area FA may be disposed between the non-folding areas NFA1 and NFA2. The second display panel DP2 may overlap one of the non-folding areas NFA1 and NFA2 in a plan view. For example, the second display panel DP2 may overlap the first non-folding area NFA1 in a plan view.

The display direction of a first image IM1a displayed on a portion (e.g., the second non-folding area NFA2) of the first display panel DP1 may be opposite to the display direction of a second image IM2a displayed on the second display panel DP2. For example, the first image IM1a may be displayed in the third direction DR3, and the second image IM2a may be displayed in a fourth direction DR4 opposite to the third direction DR3.

In an embodiment of the disclosure, the folding area FA may be bent about a folding axis extending in a direction parallel to the long sides of the electronic device 1000 (e.g., in a direction parallel to the second direction DR2). The folding area FA may have a curvature (e.g., a predetermined or selectable curvature) and a radius (e.g., a predetermined or selectable radius) of curvature in a folded state of the electronic device 1000. The electronic device 1000 may be folded in an in-folding manner. The first non-folding area NFA1 and the second non-folding area NFA 2 may face each other, and the first display part DA1-F may not be exposed to the outside.

In an embodiment of the disclosure, the electronic device 1000 may be folded in an out-folding manner, and the first display part DA1-F may be exposed to the outside. In an embodiment of the disclosure, the electronic device 1000 may be folded in an in-folding or out-folding manner in the unfolded state. However, the disclosure is not limited thereto.

In FIG. 1A, a folding area FA (e.g., a single folding area FA) may be defined (or, provided or included) in the electronic device 1000. However, the disclosure is not limited thereto. For example, folding axes and folding areas corresponding to the folding axes may be defined in the electronic device 1000. In the unfolded state, the electronic device 1000 may be folded in an in-folding or out-folding manner in each of the folding areas.

According to an embodiment of the disclosure, at least one of the first display panel DP1 and the second display panel DP2 may sense an input by the pen PN without a digitizer. Since the digitizer that senses the pen PN is omitted, an increase in the thickness and weight of the electronic device 1000 and a decrease in the flexibility of the electronic device 1000 depending on the addition of the digitizer may not occur. For example, the thickness and weight of the electronic device 1000 may be decreased, and the flexibility of the electronic device 1000 may be increased by the omission of the digitizer. Accordingly, not only the first display panel DP1 but also the second display panel DP2 may be designed to sense the pen PN.

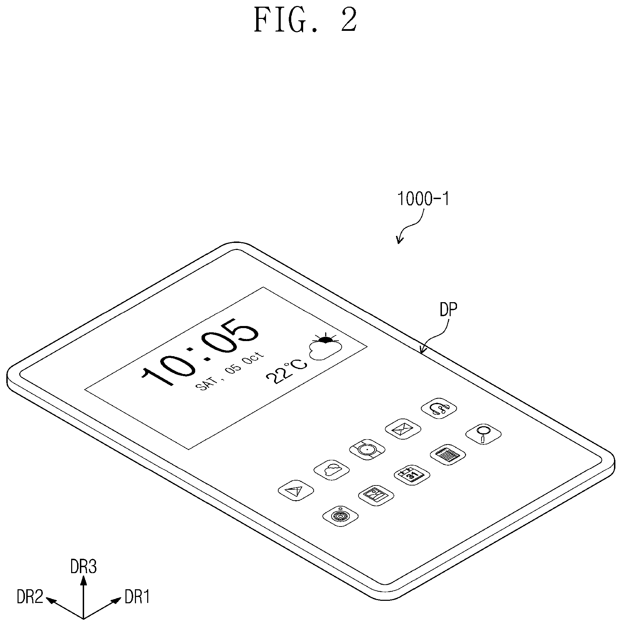

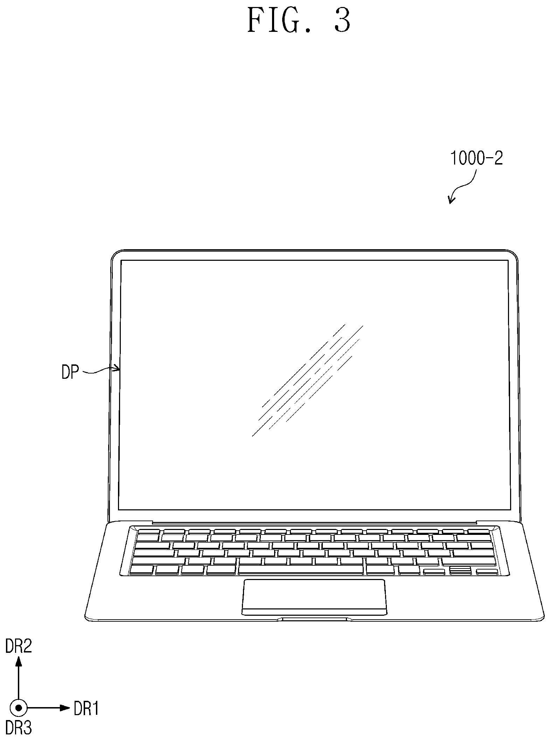

FIG. 2 is a schematic perspective view of an electronic device 1000-1 according to an embodiment of the disclosure. FIG. 3 is a schematic perspective view of an electronic device 1000-2 according to an embodiment of the disclosure.

In FIG. 2, the electronic device 1000-1 may be a portable electronic device (e.g., a mobile phone or a tablet computer), and the electronic device 1000-1 may include a display panel DP. In FIG. 3, the electronic device 1000-2 may be a notebook computer, and the electronic device 1000-2 may include the display panel DP. FIG. 3 is a schematic perspective view of the electronic device 1000-2, but the coordinate axes shown in FIG. 3 are displayed based on the display panel DP in the electronic device 1000-2.

In an embodiment of the disclosure, the display panel DP may sense an input applied from the outside. The external input may be a user input. The user input may include various types of external inputs such as a part of the user's body, the pen PN (e.g., refer to FIG. 1A), light, heat, or pressure.

According to an embodiment of the disclosure, the display panel DP may sense an input by the pen PN without a digitizer. Since the digitizer that senses the pen PN is omitted, an increase in the thickness and weight of the electronic device 1000-1 or 1000-2 depending on (e.g., caused by) the addition of the digitizer may not occur. For example, the thickness and weight of the electronic device 1000-1 or 1000-2 may be decreased by the omission of the digitizer.

The foldable electronic device 1000 is illustrated in FIG. 1A and the bar-type electronic device 1000-1 is illustrated in FIG. 2. However, the disclosure to be described below is not limited thereto. For example, the following descriptions may be applied to various electronic devices such as a rollable electronic device, a slidable electronic device, a stretchable electronic device, or the like. For example, the electronic device may be at least one of a smart watch, a mobile phone, a smartphone, a portable computer, a tablet personal computer (PC), a watch phone, an automotive display, a smart glass, a portable multimedia player (PMP), a navigation system, an ultra-mobile computer (UMPC), a head mounted display (HMD) device, a virtual reality (VR) device, a mixed reality (MR) device, and an augmented reality (AR) device.

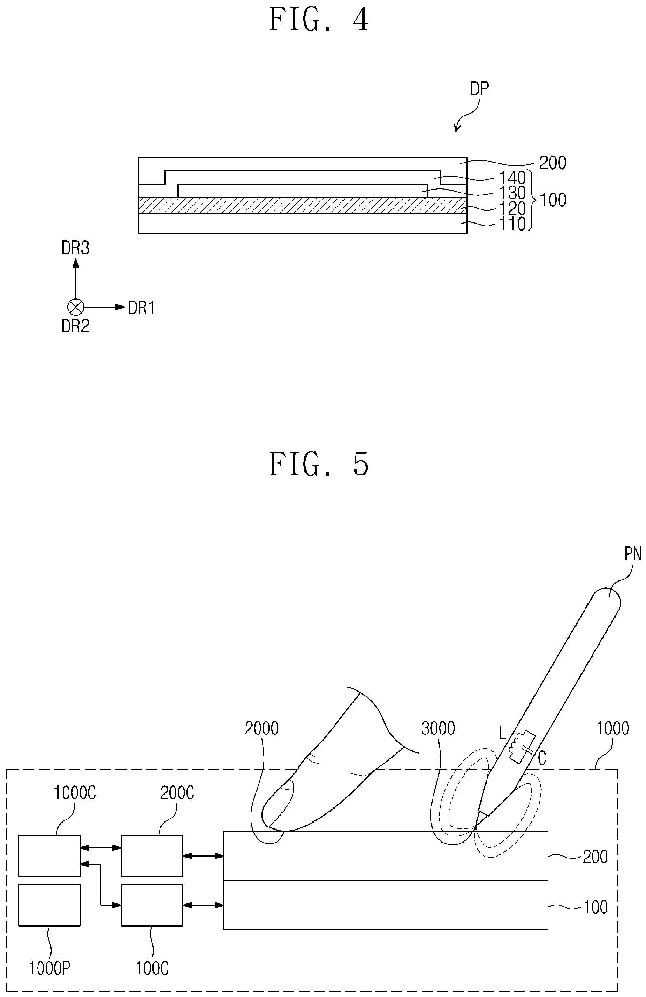

FIG. 4 is a schematic cross-sectional view of the display panel DP according to an embodiment of the disclosure.

Referring to FIG. 4, the display panel DP may include a display layer 100 and a sensor layer 200.

The display layer 100 may generate an image. The display layer 100 may be an emissive display layer (or may emit light independently). For example, the display layer 100 may be an organic light emitting display layer, an inorganic light emitting display layer, an organic-inorganic light emitting display layer, a quantum-dot display layer, a micro-LED display layer, a nano-LED display layer, or the like. The display layer 100 may include a base layer 110, a circuit layer 120, a light emitting element layer 130, and an encapsulation layer 140.

The base layer 110 may provide a base surface on which the circuit layer 120 is disposed. The base layer 110 may have a multi-layer structure or a single-layer structure. The base layer 110 may be a glass substrate, a metal substrate, a silicon substrate, a polymer substrate, or the like, but is not limited thereto.

The circuit layer 120 may be disposed on the base layer 110. The circuit layer 120 may include an insulating layer, a semiconductor pattern, a conductive pattern, a signal line, or the like. An insulating layer, a semiconductor layer, and a conductive layer may be formed on the base layer 110 through a process such as coating or deposition. The insulating layer, the semiconductor layer, and the conductive layer may be selectively patterned by performing multiple photolithography processes.

The light emitting element layer 130 may be disposed on the circuit layer 120. The light emitting element layer 130 may include a light emitting element. For example, the light emitting element layer 130 may include at least one of an organic luminescent material, an inorganic luminescent material, an organic-inorganic luminescent material, a quantum dot, a quantum rod, a micro LED, and a nano LED. However, the disclosure is not limited thereto.

The encapsulation layer 140 may be disposed on the light emitting element layer 130. The encapsulation layer 140 may protect the light emitting element layer 130 from moisture, oxygen, foreign matter such as dust particles, or the like.

The sensor layer 200 may be disposed on the display layer 100. The sensor layer 200 may sense an external input applied from the outside. The sensor layer 200 may be an integrated sensor continuously formed in a process of manufacturing the display layer 100. In other embodiments, the sensor layer 200 may be an external sensor attached to the display layer 100. The sensor layer 200 may be referred to as a sensor, an input sensing layer, an input sensing panel, or an electronic device capable of sensing input coordinates.

According to an embodiment of the disclosure, the sensor layer 200 may sense at least one of an input by a passive input means such as a part of the user's body and an input by an input device that generates a magnetic field having a resonant frequency (e.g., a predetermined or selectable resonant frequency). For example, the sensor layer 200 may sense both the input by the passive input means and the input by the input device. The input device may be referred to as a pen, an input pen, a magnetic pen, a stylus pen, an electromagnetic resonance pen, or the like.

FIG. 5 is a schematic view for explaining an operation of the electronic device 1000 according to an embodiment of the disclosure.

Referring to FIG. 5, the electronic device 1000 may include the display layer 100, the sensor layer 200, a display driver 100C, a sensor driver 200C, a main driver 1000C, and a power circuit 1000P.

The sensor layer 200 may sense a first input 2000 or a second input 3000 applied from the outside. Each of the first input 2000 and the second input 3000 may be an input by an input means capable of changing the capacitance of the sensor layer 200 or an input by an input means capable of causing an induced current in the sensor layer 200. For example, the first input 2000 may be an input by a passive input means such as a part of the user's body. The second input 3000 may be an input by the pen PN or an input by an RFIC tag. For example, the pen PN may be a passive type or an active type.

In an embodiment of the disclosure, the pen PN may generate a magnetic field having a resonant frequency (e.g., a predetermined or selectable resonant frequency). The pen PN may transmit an output signal based on an electromagnetic resonance scheme. The pen PN may be referred to as an input device, an input pen, a magnetic pen, a stylus pen, an electromagnetic resonance pen, or the like.

The pen PN may include an RLC resonance circuit, and the RLC resonance circuit may include an inductor L and a capacitor C. In an embodiment of the disclosure, the RLC resonance circuit may be a variable resonance circuit that varies the resonant frequency. The inductor L may be a variable inductor, and/or the capacitor C may be a variable capacitor. However, the disclosure is not limited thereto.

The inductor L may generate a current by a magnetic field formed in the electronic device 1000 (e.g., in the sensor layer 200 of the electronic device 1000). However, the disclosure is not limited thereto. For example, in case that the pen PN operates in an active type, the pen PN may generate a current even though a magnetic field is not provided to the pen PN from the outside. The generated current may be transferred to the capacitor C. The capacitor C may charge the current input from the inductor L and discharge the charged current to the inductor L. The inductor L may emit a magnetic field having a resonant frequency (e.g., a predetermined or selectable resonant frequency). An induced current may flow in the sensor layer 200 by the magnetic field emitted from the pen PN. The induced current may be transferred to the sensor driver 200C as a reception signal (or, a sensing signal or a signal).

The main driver 1000C may control overall operation of the electronic device 1000. For example, the main driver 1000C may control operations of the display driver 100C and the sensor driver 200C. The main driver 1000C may include at least one microprocessor and may further include a graphic controller. The main driver 1000C may be referred to as an application processor, a central processing unit, a main processor, or the like.

The display driver 100C may drive the display layer 100. The display driver 100C may receive image data and a control signal from the main driver 1000C. The control signal may include various signals. For example, the control signal may include an input vertical synchronization signal, an input horizontal synchronization signal, a main clock signal, a data enable signal, or the like.

The sensor driver 200C may drive the sensor layer 200. The sensor driver 200C may receive a control signal from the main driver 1000C. The control signal may include a clock signal of the sensor driver 200C. The control signal may further include a mode determination signal for determining an operation mode of the sensor driver 200C and the sensor layer 200.

The sensor driver 200C may be implemented with an integrated circuit (IC) and may be electrically connected to the sensor layer 200. For example, the sensor driver 200C may be mounted on (e.g., be directly mounted on) an area (e.g., a predetermined or selectable area) of the display panel. In other embodiments, the sensor driver 200C may be mounted on a separate printed circuit board using a chip on film (COF) method and may be electrically connected to the sensor layer 200.

The sensor driver 200C and the sensor layer 200 may selectively operate in at least one of a first mode and a second mode. For example, the sensor driver 200C and the sensor layer 200 may selectively operate in the first mode or the second mode. For example, the first mode may sense a touch input (e.g., the first input 2000. The second mode may sense an input by the pen PN (e.g., the second input 3000) For example, the touch input (e.g., the first input 2000) may be sensed in the first mode, and the input by the pen PN (e.g., the second input 3000) may be sensed in the second mode). The first mode may be referred to as a touch sensing mode, and the second mode may be referred to as a pen sensing mode.

Switching between the first mode and the second mode may be performed in various ways. For example, the sensor driver 200C and the sensor layer 200 may be driven in the first mode and in the second mode in a time-division manner and may sense the first input 2000 and the second input 3000. In other embodiments, the switching between the first mode and the second mode may be performed by the user's selection or the user's action (e.g., an input by the user). In another embodiment, by activation or deactivation of an application (e.g., a specific or selectable application), one of the first mode and the second mode may be activated or deactivated, or the operation mode may be switched from a mode to another mode. In yet another embodiment, in case that the first input 2000 is sensed while the sensor driver 200C and the sensor layer 200 alternately operate in the first mode and in the second mode, the sensor driver 200C and the sensor layer 200 may remain in the first mode, and in case that the second input 3000 is sensed, the sensor driver 200C and the sensor layer 200 may remain in the second mode. For example, in case that the sensor driver 200C and the sensor layer 200 may alternately operate in the first mode and in the second mode, the sensor driver 200C and the sensor layer 200 may be maintained to be in the first mode by the sense of the first input 2000 and may be maintained to be the second mode by the sense of the second input 3000.

The sensor driver 200C may calculate coordinate information of an input based on a signal received from the sensor layer 200 and may provide a coordinate signal having the coordinate information to the main driver 1000C. The main driver 1000C may execute an operation corresponding to the user input, based on the coordinate signal. For example, the main driver 1000C may operate the display driver 100C, and a new application image may be displayed on the display layer 100.

The power circuit 1000P may include a power management integrated circuit (PMIC). The power circuit 1000P may generate drive voltages for driving the display layer 100, the sensor layer 200, the display driver 100C, and the sensor driver 200C. For example, the drive voltages may include a gate high-voltage, a gate low-voltage, a first drive voltage (e.g., an ELVSS voltage), a second drive voltage (e.g., an ELVDD voltage), an initialization voltage, or the like, but are not limited to the examples.

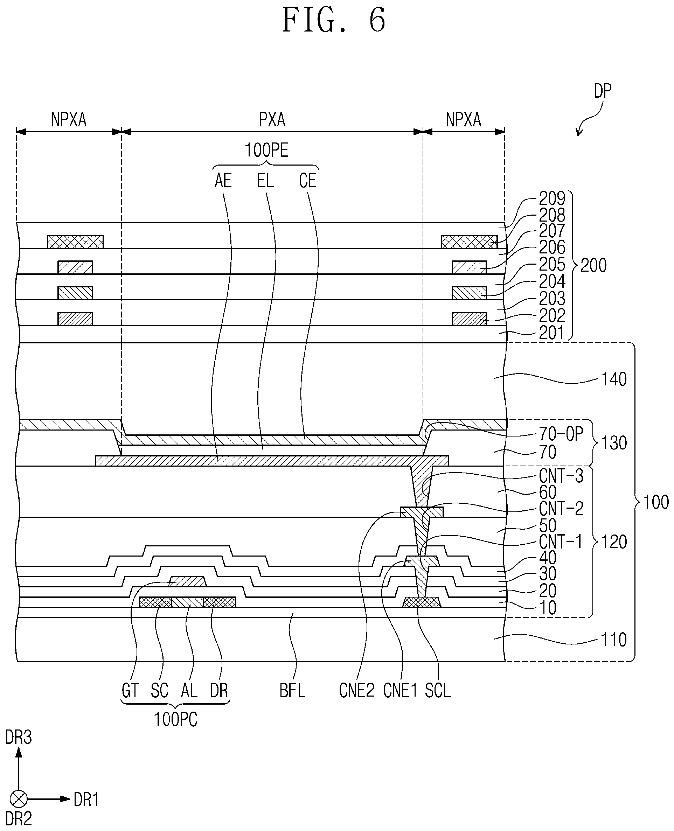

FIG. 6 is a schematic cross-sectional view of the display panel DP according to an embodiment of the disclosure.

Referring to FIG. 6, at least one buffer layer BFL may be formed on the upper surface of the base layer 110. The buffer layer BFL may improve the coupling force between the base layer 110 and a semiconductor pattern SC, AL, DR, and SCL. The buffer layer BFL may be formed of multiple layers. In other embodiments, the display layer 100 may further include a barrier layer. The buffer layer BFL may include at least one of silicon oxide, silicon nitride, and silicon oxy nitride. However, the disclosure is not limited thereto, and the buffer layer BFL may include various materials. For example, the buffer layer BFL may include a structure in which silicon oxide layers and silicon nitride layers are alternately stacked one above another.

The semiconductor pattern SC, AL, DR, and SCL may be disposed on the buffer layer BFL. The semiconductor pattern SC, AL, DR, and SCL may include poly silicon. The semiconductor pattern SC, AL, DR, and SCL may include at least one of amorphous silicon, low-temperature polycrystalline silicon, and an oxide semiconductor. However, the disclosure is not limited thereto, and the semiconductor pattern SC, AL, DR, and SCL may include various materials.

In FIG. 6, only a portion of the semiconductor pattern SC, AL, DR, and SCL may be disposed on the buffer layer BFL. However, the disclosure is not limited thereto, and a semiconductor pattern may be additionally disposed in other areas. The semiconductor pattern SC, AL, DR, and SCL may be disposed (e.g., arranged) over pixels according to a rule (e.g., a specific or selectable rule or arrangement). The semiconductor pattern SC, AL, DR, and SCL may have different electrical properties depending on whether doping is performed or not. The semiconductor pattern SC, AL, DR, and SCL may include first areas SC, DR, and SCL having a high conductivity and a second area AL having a low conductivity. The first areas SC, DR, and SCL may be doped with an N-type dopant or a P-type dopant. A P-type transistor may include a doped area doped with a P-type dopant, and an N-type transistor may include a doped area doped with an N-type dopant. The second area AL may be a non-doped area or may be an area more lightly doped than the first areas SC, DR, and SCL.

The first areas SC, DR, and SCL may have a higher conductivity than the second area AL and may substantially serve as (or be implemented with) electrodes or signal lines. The second area AL may substantially correspond to (or be implemented with) an active area AL (or, a channel) of a transistor 100PC. For example, a portion AL of the semiconductor pattern SC, AL, DR, and SCL may be the active area AL of the transistor 100PC, another portion SC or DR may be a source area SC or a drain area DR of the transistor 100PC, and another portion SCL may be a connecting electrode or a connecting signal line SCL.

Each of the pixels may have an equivalent circuit including transistors, at least one capacitor, and at least one light emitting element, and the equivalent circuit of the pixel may be modified in various forms. In FIG. 6, a transistor 100PC and a light emitting element 100PE may be included in each pixel.

The source area SC, the active area AL, and the drain area DR of the transistor 100PC may be formed from the semiconductor pattern SC, AL, DR, and SCL. The source area SC and the drain area DR may extend from the active area AL in opposite directions on the cross-section. In FIG. 6, a portion of the connecting signal line SCL may be formed from the semiconductor pattern SC, AL, DR, and SCL. Although not separately illustrated, the connecting signal line SCL may be electrically connected to the drain area DR of the transistor 100PC in a plan view.

A first insulating layer 10 may be disposed on the buffer layer BFL. The first insulating layer 10 may overlap (e.g., commonly overlap) the pixels in a plan view and may cover the semiconductor pattern SC, AL, DR, and SCL. The first insulating layer 10 may be an inorganic layer and/or an organic layer and may have a single-layer structure or a multi-layer structure. The first insulating layer 10 may include at least one of aluminum oxide, titanium oxide, silicon oxide, silicon nitride, silicon oxy nitride, zirconium oxide, and hafnium oxide. However, the disclosure is not limited thereto. In this embodiment, the first insulating layer 10 may be a single silicon oxide layer. The first insulating layer 10 and insulating layers of the circuit layer 120 may be inorganic layers and/or organic layers, and may have a single-layer structure or a multi-layer structure. Detailed description of the insulating layers of the circuit layer 120 is provided below. The inorganic layers may include at least one of the aforementioned materials, but are not limited thereto.

A gate GT of the transistor 100PC may be disposed on the first insulating layer 10. The gate GT may be a portion of a metal pattern. The gate GT overlaps the active area AL in a plan view. The gate GT may function as (or be implemented with) a mask in a process of doping or reducing the semiconductor pattern SC, AL, DR, and SCL. For example, the semiconductor pattern SC, AL, DR, and SCL may be formed using the gate GT as the mask (e.g., the doping or reducing mask).

A second insulating layer 20 may be disposed on the first insulating layer 10 and may cover the gate GT. The second insulating layer 20 may overlap (e.g., commonly overlap) the pixels in a plan view. The second insulating layer 20 may be an inorganic layer and/or an organic layer and may have a single-layer structure or a multi-layer structure. The second insulating layer 20 may include at least one of silicon oxide, silicon nitride, and silicon oxy nitride. However, the disclosure is not limited thereto. In this embodiment, the second insulating layer 20 may have a multi-layer structure including at least one silicon oxide layer and at least one silicon nitride layer.

A third insulating layer 30 may be disposed on the second insulating layer 20. The third insulating layer 30 may have a single-layer structure or a multi-layer structure. For example, the third insulating layer 30 may have a multi-layer structure including at least one silicon oxide layer and at least one silicon nitride layer.

A first connecting electrode CNE1 may be disposed on the third insulating layer 30. The first connecting electrode CNE1 may be electrically connected to the connecting signal line SCL through a contact hole CNT-1 that penetrates the first insulating layer 10, the second insulating layer 20, and the third insulating layer 30.

A fourth insulating layer 40 may be disposed on the third insulating layer 30. The fourth insulating layer 40 may be a single silicon oxide layer. A fifth insulating layer 50 may be disposed on the fourth insulating layer 40. The fifth insulating layer 50 may be an organic layer.

A second connecting electrode CNE2 may be disposed on the fifth insulating layer 50. The second connecting electrode CNE2 may be electrically connected to the first connecting electrode CNE1 through a contact hole CNT-2 that penetrates the fourth insulating layer 40 and the fifth insulating layer 50.

A sixth insulating layer 60 may be disposed on the fifth insulating layer 50 and may cover the second connecting electrode CNE2. The sixth insulating layer 60 may be an organic layer.

The light emitting element layer 130 may be disposed on the circuit layer 120. The light emitting element layer 130 may include the light emitting element 100PE. For example, the light emitting element layer 130 may include at least one of an organic luminescent material, an inorganic luminescent material, an organic-inorganic luminescent material, a quantum dot, a quantum rod, a micro LED, and a nano LED. However, the disclosure is not limited thereto. Hereinafter, the light emitting element 100PE may be an organic light emitting element. However, the disclosure is not limited thereto.

The light emitting element 100PE may include a first electrode AE, an emissive layer EL, and a second electrode CE.

The first electrode AE may be disposed on the sixth insulating layer 60. The first electrode AE may be electrically connected to the second connecting electrode CNE2 through a contact hole CNT-3 that penetrates the sixth insulating layer 60.

A pixel defining layer 70 may be disposed on the sixth insulating layer 60 and may cover a portion of the first electrode AE. The pixel defining layer 70 may have an opening 70-OP defined in the pixel defining layer 70. The opening 70-OP of the pixel defining layer 70 may expose at least a portion of the first electrode AE.

The first display part DA1-F (e.g., refer to FIG. 1A) may include an emissive area PXA and a non-emissive area NPXA adjacent to the emissive area PXA. The non-emissive area NPXA may surround the emissive area PXA. In this embodiment, the emissive area PXA may correspond to a partial area of the first electrode AE exposed through the opening 70-OP.

The emissive layer EL may be disposed on the first electrode AE. The emissive layer EL may be disposed in an area corresponding to the opening 70-OP. In FIG. 6, the emissive layer EL may be disposed in the opening 70-OP. However, the disclosure is not limited thereto. For example, the emissive layer EL may extend to cover the side surface of the pixel defining layer 70 that defines the opening 70-OP and a portion of the upper surface of the pixel defining layer 70.

In an embodiment of the disclosure, the emissive layer EL may be separately formed in each of the pixels. In case that the emissive layer EL is separately formed in each of the pixels, the emissive layers EL may each emit at least one of blue light, red light, and green light. However, the disclosure is not limited thereto, and the emissive layer EL may have a one-body shape and may be included (e.g., commonly included) in the pixels. For example, multiple pixels may commonly include the emissive layer EL. The emissive layer EL may provide blue light or white light.

The second electrode CE may be disposed on the emissive layer EL. The second electrode CE may have a one-body shape and may be included (e.g., commonly included) in the pixels. For example, multiple pixels may commonly include the second electrode CE.

In an embodiment of the disclosure, a hole control layer may be disposed between the first electrode AE and the emissive layer EL. The hole control layer may be disposed (e.g., commonly disposed) in the emissive area PXA and the non-emissive area NPXA. The hole control layer may include a hole transport layer and may further include a hole injection layer. An electron control layer may be disposed between the emissive layer EL and the second electrode CE. The electron control layer may include an electron transport layer and may further include an electron injection layer. The hole control layer and the electron control layer may be formed (e.g., commonly formed) in the pixels using an open mask or an ink-jet process. For example, multiple pixels may commonly include the hole control layer and the electron control layer.

The encapsulation layer 140 may be disposed on the light emitting element layer 130. The encapsulation layer 140 may include an inorganic layer, an organic layer, and an inorganic layer sequentially stacked one above another. However, layers constituting the encapsulation layer 140 are not limited thereto. The inorganic layers may protect the light emitting element layer 130 from moisture and oxygen, and the organic layer may protect the light emitting element layer 130 from foreign matter such as dust particles. The inorganic layers may include a silicon nitride layer, a silicon oxy nitride layer, a silicon oxide layer, a titanium oxide layer, an aluminum oxide layer, or the like. The organic layer may include an acrylic organic layer, but is not limited thereto.

The sensor layer 200 may include a base layer 201, a first conductive layer 202, a first intermediate insulating layer 203, a second conductive layer 204, a second intermediate insulating layer 205, a third conductive layer 206, a third intermediate insulating layer 207, a fourth conductive layer 208, and a cover insulating layer 209.

The display layer 100 may display an image in a direction toward the sensor layer 200, and the first conductive layer 202, the second conductive layer 204, the third conductive layer 206, and the fourth conductive layer 208 may be sequentially stacked in a direction away from the display layer 100.

The base layer 201 may be an inorganic layer including at least one of silicon nitride, silicon oxy nitride, and silicon oxide. In other embodiments, the base layer 201 may be an organic layer including at least one of an epoxy resin, an acrylic resin, and an imide-based resin. However, the disclosure is not limited thereto. The base layer 201 may have a single-layer structure or may have a multi-layer structure stacked in the third direction DR3. In an embodiment of the disclosure, the sensor layer 200 may not include the base layer 201.

Each of the first conductive layer 202, the second conductive layer 204, the third conductive layer 206, and the fourth conductive layer 208 may have a single-layer structure or may have a multi-layer structure stacked in the third direction DR3.

Each of the first conductive layer 202, the second conductive layer 204, the third conductive layer 206, and the fourth conductive layer 208 that have a single-layer structure may include a metal layer or a transparent conductive layer. The metal layer may include at least one of molybdenum, silver, titanium, copper, and aluminum. For example, the metal layer may include an alloy thereof. The transparent conductive layer may include transparent conductive oxide including at least one of indium tin oxide (ITO), indium zinc oxide (IZO), zinc oxide (ZnO), and indium zinc tin oxide (IZTO). However, the disclosure is not limited thereto. The transparent conductive layer may include a conductive polymer such as poly(3,4-ethylenedioxythiophene) (PEDOT), a metal nano wire, or graphene.

Each of the first conductive layer 202, the second conductive layer 204, the third conductive layer 206, and the fourth conductive layer 208 that have a multi-layer structure may include metal layers. The meal layers may have, for example, a three-layer structure of titanium/aluminum/titanium. The conductive layer having the multi-layer structure may include at least one metal layer and at least one transparent conductive layer.

At least one of the first intermediate insulating layer 203, the second intermediate insulating layer 205, the third intermediate insulating layer 207, and the cover insulating layer 209 may include an inorganic film. The inorganic film may include at least one of aluminum oxide, titanium oxide, silicon oxide, silicon nitride, silicon oxy nitride, zirconium oxide, and hafnium oxide. However, the disclosure is not limited thereto.

At least one of the first intermediate insulating layer 203, the second intermediate insulating layer 205, the third intermediate insulating layer 207, and the cover insulating layer 209 may include an organic film. The organic film may include at least one of an acrylic resin, a methacrylic resin, a polyisoprene resin, a vinyl resin, an epoxy resin, a urethane-based resin, a cellulosic resin (or cellulose resin), a siloxane-based resin, a polyimide resin, a polyamide resin, and a perylene-based resin. However, the disclosure is not limited thereto.

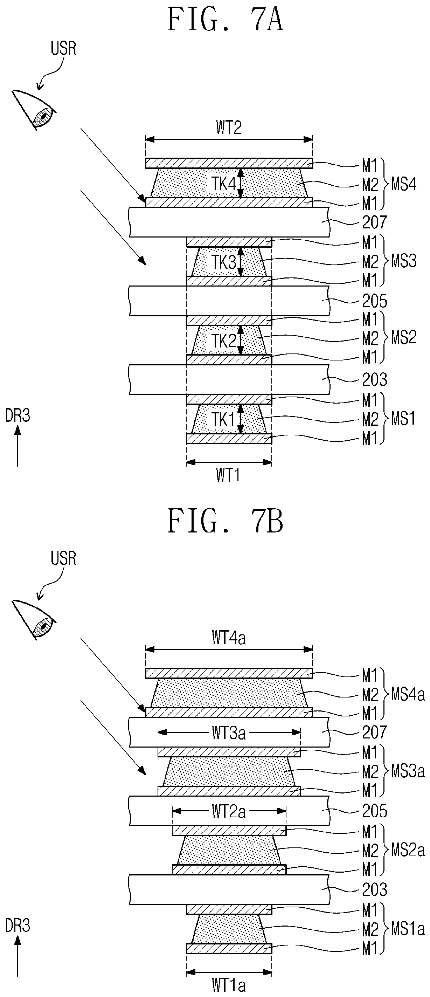

FIG. 7A is a schematic cross-sectional view illustrating some components of the sensor layer 200 according to an embodiment of the disclosure.

Referring to FIGS. 6 and 7A, each of the first to fourth conductive layers 202, 204, 206, and 208 may have a mesh structure in which openings are defined. Accordingly, light output from the display layer 100 may be output to the outside of the electronic device 1000 (e.g., refer to FIG. 1A) through the openings defined in the first to fourth conductive layers 202, 204, 206, and 208.

The first conductive layer 202 may include a first mesh line MS1, the second conductive layer 204 may include a second mesh line MS2, the third conductive layer 206 may include a third mesh line MS3, and the fourth conductive layer 208 may include a fourth mesh line MS4.

In an embodiment of the disclosure, each of the first mesh line MS1, the second mesh line MS2, the third mesh line MS3, and the fourth mesh line MS4 may include first metal layers M1 and a second metal layer M2 disposed between the first metal layers M1. For example, the first metal layers M1 may include titanium (Ti), and the second metal layer M2 may include aluminum (Al). However, this is only an example, and the disclosure is not limited thereto.

In an embodiment of the disclosure, the first to fourth thicknesses TK1, TK2, TK3, and TK4 of the second metal layers M2 of the first to fourth mesh lines MS1, MS2, MS3, and MS4 may be substantially the same as one another, but are not limited thereto. For example, at least one of the first to fourth thicknesses TK1, TK2, TK3, and TK4 may be different from at least one other thickness.

For example, the first thickness TK1 and the second thickness TK2 may be greater than the third thickness TK3 and the fourth thickness TK4. The resistances of components (e.g., electrodes, patterns, or bridge patterns) included in the first conductive layer 202 and the second conductive layer 204 may be decreased. The probability that the components included in the first conductive layer 202 and the second conductive layer 204 will be visually recognized due to the reflection of external light may be lower than that of the fourth conductive layer 208 even though the thicknesses of the first conductive layer 202 and the second conductive layer 204 are increased. For example, although the thicknesses of the first conductive layer 202 and the second conductive layer 204 are increased, the components (e.g., the first and second mesh lines MS1 and MS2) in the first conductive layer 202 and the second conductive layer 204 may be blocked by the component (e.g., the fourth mesh line MS4) in the fourth conductive layer 208 and may not be visually recognized to the outside.

In an embodiment of the disclosure, the width of the fourth mesh line MS4 may be greater than the width of the third mesh line MS3, and the width of the third mesh line MS3 may be greater than or equal to the width of the first mesh line MS1 and may be greater than or equal to the width of the second mesh line MS2. For example, each of the first to third mesh lines MS1, MS2, and MS3 may have a first width WT1, and the fourth mesh line MS4 may have a second width WT2. For example, the first width WT1 may be smaller than the second width WT2.

In case that a user USR looks at the electronic device 1000 (e.g., refer to FIG. 1A) from the side, the probability that the first to third mesh lines MS1, MS2, and MS3 will be visually recognized by the user USR may be reduced because the first to third mesh lines MS1, MS2, and MS3 have a smaller width than the fourth mesh line MS4. For example, the first to third mesh lines MS1, MS2, and MS3 may be blocked by the fourth mesh line MS4, and the first to third mesh lines MS1, MS2, and MS3 may not be visually recognized by the user USR.

FIG. 7B is a schematic cross-sectional view illustrating some components of the sensor layer 200according to an embodiment of the disclosure. In FIG. 7B, components according to the embodiment are different from those of FIG. 7A, at least in respect of the widths of the first to fourth mesh lines MS1a, MS2a, MS3a, and MS4a. Detailed description of the same or similar constituent elements is omitted.

Referring to FIGS. 6 and 7B, a first mesh line MS1a may have a first width WT1a, a second mesh line MS2a may have a second width WT2a, a third mesh line MS3a may have a third width WT3a, and a fourth mesh line MS4a may have a fourth width WT4a.

In an embodiment of the disclosure, the fourth width WT4a may be greater than the third width WT3a, the third width WT3a may be greater than the second width WT2a, and the second width WT2a may be greater than the first width WT1a. In case that the user USR looks at the electronic device 1000 (e.g., refer to FIG. 1A) from the side, the probability that the first to third mesh lines MS1a, MS2a, and MS3a will be visually recognized by the user USR may be reduced because the first to third mesh lines MS1a, MS2a, and MS3a have a smaller width than the fourth mesh line MS4a. For example, the first to third mesh lines MS1a, MS2a, and MS3a may be blocked by the fourth mesh line MS4a, and the first to third mesh lines MS1a, MS2a, and MS3a may not be visually recognized by the user USR.

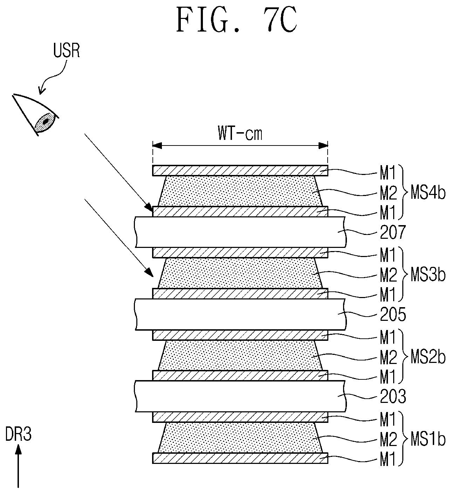

FIG. 7C is a schematic cross-sectional view illustrating some components of the sensor layer 200 according to an embodiment of the disclosure. In FIG. 7C, components of the embodiment are different from those of FIG. 7A, at least in respect of the widths of the first to fourth mesh lines MS1b, MS2b, MS3b, and MS4b. Detailed description of the same or similar constituent elements is omitted.

Referring to FIGS. 6 and 7C, a first mesh line MS1b, a second mesh line MS2b, a third mesh line MS3b, and a fourth mesh line MS4b may have substantially the same width WT-cm. Accordingly, in a cross-sectional view, the first mesh line MS1b, the second mesh line MS2b, the third mesh line MS3b, and the fourth mesh line MS4b may have shapes aligned with one another.

Each of the first mesh line MS1b, the second mesh line MS2b, the third mesh line MS3b, and the fourth mesh line MS4b may be designed to have the maximum width that is able to be designed. Accordingly, the resistance of each of the first mesh line MS1b, the second mesh line MS2b, the third mesh line MS3b, and the fourth mesh line MS4b may be decreased.

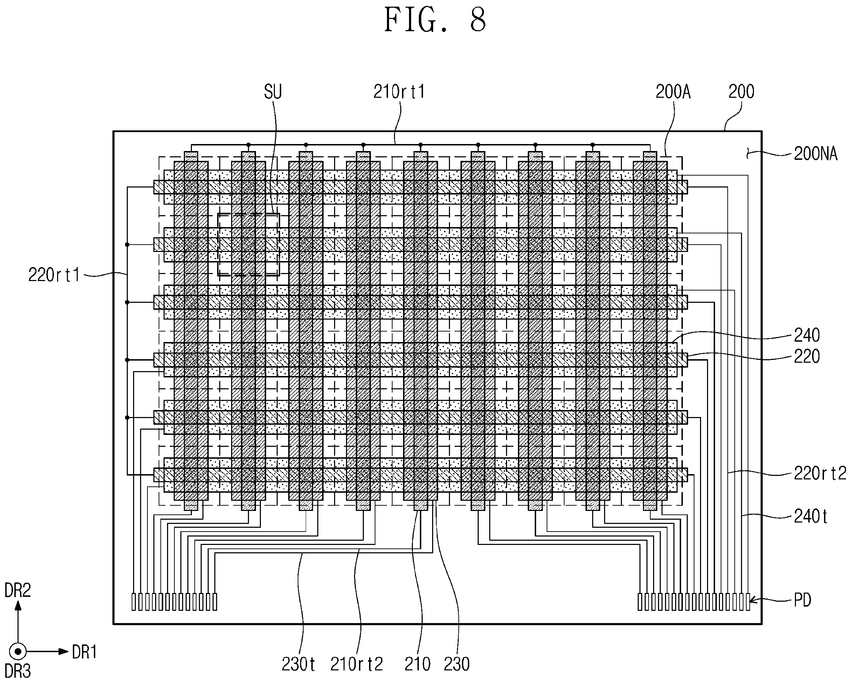

FIG. 8 is a schematic plan view of the sensor layer 200 according to an embodiment of the disclosure.

Referring to FIG. 8, a sensing area 200A and a peripheral area 200NA adjacent to the sensing area 200A may be defined in the sensor layer 200.

The sensor layer 200 may include first electrodes 210, second electrodes 220, third electrodes 230, and fourth electrodes 240 disposed in the sensing area 200A.

Each of the first electrodes 210 may extend in the second direction DR2. The first electrodes 210 may be spaced apart from one another in the first direction DR1. The second electrodes 220 may be disposed (e.g., arranged) in the second direction DR2. The second electrodes 220 may extend in the first direction DR1.

The first electrodes 210 and the second electrodes 220 may each provide a magnetic field. Accordingly, the pen PN (e.g., refer to FIG. 5) adjacent to the sensor layer 200 may be charged by the magnetic fields provided from the first electrodes 210 or the second electrodes 220 and may emit a magnetic field. Induced currents may flow through the first electrodes 210 and the second electrodes 220 due to the magnetic field emitted from the pen PN.

The third electrodes 230 and the fourth electrodes 240 may be electrodes used to detect the coordinates of the first input 2000 (e.g., refer to FIG. 5). For example, the input coordinates may be detected by sensing a change in the mutual capacitance between the third electrodes 230 and the fourth electrodes 240 or by sensing a change in the capacitance of each of the third electrodes 230 and the fourth electrodes 240.

Each of the third electrodes 230 may intersect (e.g., cross) the fourth electrodes 240. Each of the third electrodes 230 may extend in the second direction DR2. The third electrodes 230 may be spaced apart from one another in the first direction DR1. Each of the fourth electrodes 240 may extend in the first direction DR1. The fourth electrodes 240 may be spaced apart from one another in the second direction DR2. A sensing part SU of the sensor layer 200 may be disposed in an area where a third electrode 230 and a fourth electrode 240 intersect (e.g., cross) each other.

In FIG. 8, the sensor layer 200 may include nine third electrodes 230, six fourth electrodes 240, and 54 sensing parts SU. However, the number of third electrodes 230 and the number of fourth electrodes 240 are not limited thereto.

According to an embodiment of the disclosure, the sensor layer 200 may further include a first loop trace line 210rt1, second loop trace lines 210rt2, a third loop trace line 220rt1, fourth loop trace lines 220rt2, first trace lines 230t, and second trace lines 240t.

The first loop trace line 210rt1, the second loop trace lines 210rt2, the third loop trace line 220rt1, the fourth loop trace lines 220rt2, the first trace lines 230t, and the second trace lines 240t may be disposed in the peripheral area 200NA, but are not limited thereto. For example, at least some of the first loop trace line 210rt1, the second loop trace lines 210rt2, the third loop trace line 220rt1, the fourth loop trace lines 220rt2, the first trace lines 230t, and the second trace lines 240t may be disposed in the sensing area 200A.

The first loop trace line 210rt1 may be electrically connected to first ends of the first electrodes 210. For example, the first electrodes 210 may all be electrically connected to the first loop trace line 210rt1. Each of the second loop trace lines 210rt2 may be electrically connected to at least one of the first electrodes 210. In FIG. 8, the second loop trace lines 210rt2 may be electrically connected to the first electrodes 210 in a one-to-one correspondence. For example, the second loop trace lines 210rt2 may be electrically connected to the first electrodes 210, respectively.

The third loop trace line 220rt1 may be electrically connected to first ends of the second electrodes 220. For example, the second electrodes 220 may all be electrically connected to the third loop trace line 220rt1. Each of the fourth loop trace lines 220rt2 may be electrically connected to at least one of the second electrodes 220. In FIG. 8, the fourth loop trace lines 220rt2 may be electrically connected to the second electrodes 220 in a one-to-one correspondence. For example, the fourth loop trace lines 220rt2 may be electrically connected to the second electrodes 220, respectively.

The first trace lines 230t may be electrically connected to the third electrodes 230 in a one-to-one correspondence. For example, the first trace lines 230t may be electrically connected to the third electrodes 230, respectively. The second trace lines 240t may be electrically connected to the fourth electrodes 240 in a one-to-one correspondence. For example, the second trace lines 240t may be electrically connected to the fourth electrodes 240, respectively.

The sensor layer 200 may include pads PD disposed in the peripheral area 200NA. The pads PD may be spaced apart from one another in the first direction DR1. In FIG. 8, the pads PD may be disposed (e.g., arranged) in a row in the first direction DR1. However, the disclosure is not limited thereto. For example, the pads PD may be disposed (e.g., arranged) in rows.

The pads PD may be electrically connected to the first loop trace line 210rt1, the second loop trace lines 210rt2, the third loop trace line 220rt1, the fourth loop trace lines 220rt2, the first trace lines 230t, and the second trace lines 240t, which have been described above, in a one-to-one correspondence. For example, the pads PD may be electrically connected to the first loop trace line 210rt1, the second loop trace lines 210rt2, the third loop trace line 220rt1, the fourth loop trace lines 220rt2, the first trace lines 230t, and the second trace lines 240t, respectively.

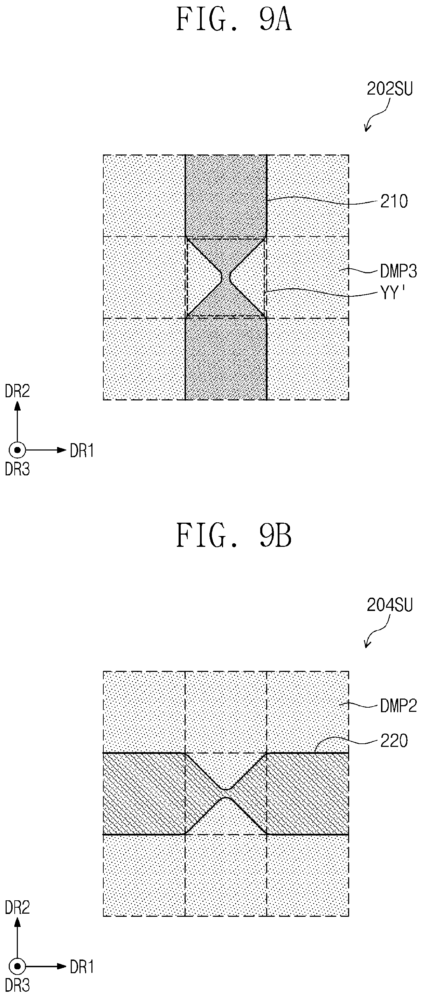

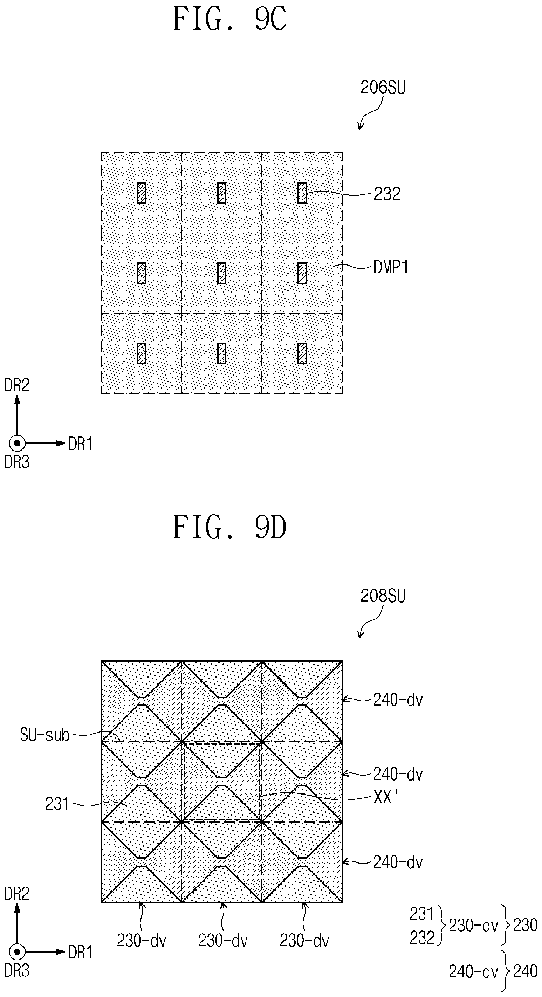

FIG. 9A is a schematic plan view illustrating a first conductive layer 202SU of the sensing part SU (e.g., refer to FIG. 8) according to an embodiment of the disclosure. FIG. 9B is a schematic plan view illustrating a second conductive layer 204SU of the sensing part SU (e.g., refer to FIG. 8) according to an embodiment of the disclosure. FIG. 9C is a schematic plan view illustrating a third conductive layer 206SU of the sensing part SU (e.g., refer to FIG. 8) according to an embodiment of the disclosure. FIG. 9D is a schematic plan view illustrating a fourth conductive layer 208SU of the sensing part SU (e.g., refer to FIG. 8) according to an embodiment of the disclosure.

Referring to FIGS. 8 and 9A to 9D, the sensing part SU may include the first electrode 210, the second electrode 220 intersecting (e.g., crossing) the first electrode 210, the third electrode 230 including patterns 231 and bridge patterns 232 disposed on a layer different from the layer on which the patterns 231 are disposed, and the fourth electrode 240 that is electrically insulated from the third electrode 230 and that intersects (e.g., crosses) the third electrode 230. The sensing part SU may further include a first dummy pattern DMP1, a second dummy pattern DMP2, and a third dummy pattern DMP3. Each of the first dummy pattern DMP1, the second dummy pattern DMP2, and the third dummy pattern DMP3 may include dummy patterns.

Referring to FIG. 9A, the first conductive layer 202SU may include the first electrode 210 and the third dummy pattern DMP3. Referring to FIGS. 9A and 9B, the second conductive layer 204SU may be disposed over the first conductive layer 202SU. The second conductive layer 204SU may include the second electrode 220 and the second dummy pattern DMP2. Referring to FIGS. 9B and 9C, the third conductive layer 206SU may be disposed over the second conductive layer 204SU. The third conductive layer 206SU may include the bridge patterns 232 and the first dummy pattern DMP1. Referring to FIGS. 9C and 9D, the fourth conductive layer 208SU may be disposed over the third conductive layer 206SU. The fourth conductive layer 208SU may include the patterns 231 and the fourth electrode 240.

Referring to FIGS. 9C and 9D, the third electrode 230 may include a first split electrodes 230-dv spaced apart from one another in the first direction DR1. The first split electrodes 230-dv may be electrically connected to each first trace line 230t (e.g., refer to FIG. 8). The fourth electrode 240 may include second split electrodes 240-dv spaced apart from one another in the second direction DR2. The second split electrodes 240-dv may be electrically connected to each second trace line 240t (e.g., refer to FIG. 8). Each first split electrode 230-dv may include the patterns 231 spaced apart from one another in the second direction DR2 and the bridge patterns 232 electrically connected to the patterns 231.

In FIG. 9D, each third electrode 230 may include three first split electrodes 230-dv, and each fourth electrode 240 may include three second split electrodes 240-dv. However, the disclosure is not limited thereto. Each third electrode 230 may include two first split electrodes 230-dv or four or more first split electrodes 230-dv. Each fourth electrode 240 may include two second split electrodes 240-dv or four or more second split electrodes 240-dv.

The sensing part SU (e.g., refer to FIG. 8) may include sub-sensing parts SU-sub. Each of the sub-sensing parts SU-sub may be disposed in an area where each first split electrode 230-dv and each second split electrode 240-dv intersect (e.g., cross) each other. Accordingly, in an embodiment, the sensing part SU may include 9 sub-sensing parts SU-sub.

Referring to FIGS. 9A, 9B, and 9C, the first electrode 210 may overlap a first split electrode 230-dv among the first split electrodes 230-dv in a plan view, and the second electrode 220 may overlap at least one second split electrode 240-dv among the second split electrodes 240-dv in a plan view. However, this is only an example, and the disclosure is not limited thereto. For example, the first electrode 210 may also include split electrodes, like the third electrode 230 which includes multiple first split electrodes 230-dv. The second electrode 220 may also include split electrodes, like the fourth electrode 240.

Referring to FIGS. 9A, 9B, 9C, and 9D, the first dummy pattern DMP1 and the bridge patterns 232 may be disposed on a same layer. The first dummy pattern DMP1 may be disposed in a layer between the second electrode 220 and the fourth electrode 240. The second dummy pattern DMP2 and the second electrode 220 may be disposed on a same layer. The second dummy pattern DMP2 may be disposed in a layer between the first electrode 210 and the bridge patterns 232. The third dummy pattern DMP3 and the first electrode 210 may be disposed on a same layer. The third dummy pattern DMP3 may overlap at least one of the second electrode 220, the bridge patterns 232, the patterns 231, and the fourth electrode 240 in a plan view.

In an embodiment of the disclosure, the second dummy patterns DMP2 may overlap the remaining second split electrodes 240-dv (or other second split electrodes 240-dv) other than the second split electrode 240-dv overlapping the second electrode 220 among the second split electrodes 240-dv in a plan view. For example, the second dummy patterns DMP2 may not overlap the second electrode 220 in a plan view. The third dummy patterns DMP3 may overlap the remaining first split electrodes 230-dv (or other first split electrodes 230-dv) other than the first split electrode 230-dv overlapping the first electrode 210 among the first split electrodes 230-dv in a plan view. For example, the third dummy pattern DMP3 may not overlap the first electrode 210 in a plan view.

According to an embodiment of the disclosure, the first to third conductive layers 202SU, 204SU, and 206SU may include the first to third dummy patterns DMP1, DMP2, and DMP3. Accordingly, a difference in wiring density between the first to fourth conductive layers 202SU, 204SU, 206SU, and 208SU may be decreased as the first to third dummy patterns DMP1, DMP2, and DMP3 are added. Since the wiring density difference is decreased, a deviation depending on the reflection of external light may be decreased, and thus the probability that the patterns will be visually recognized by the user may be reduced.

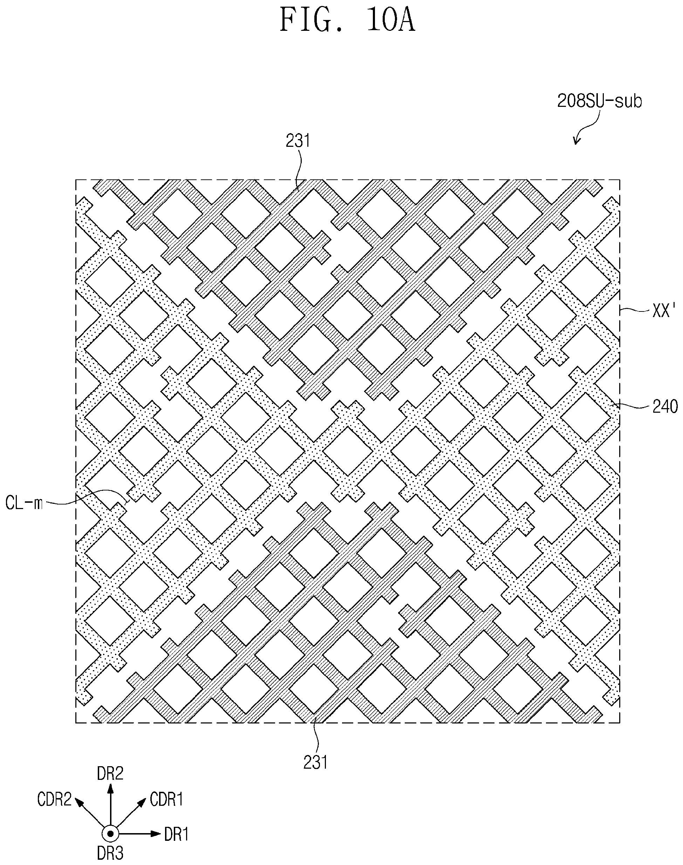

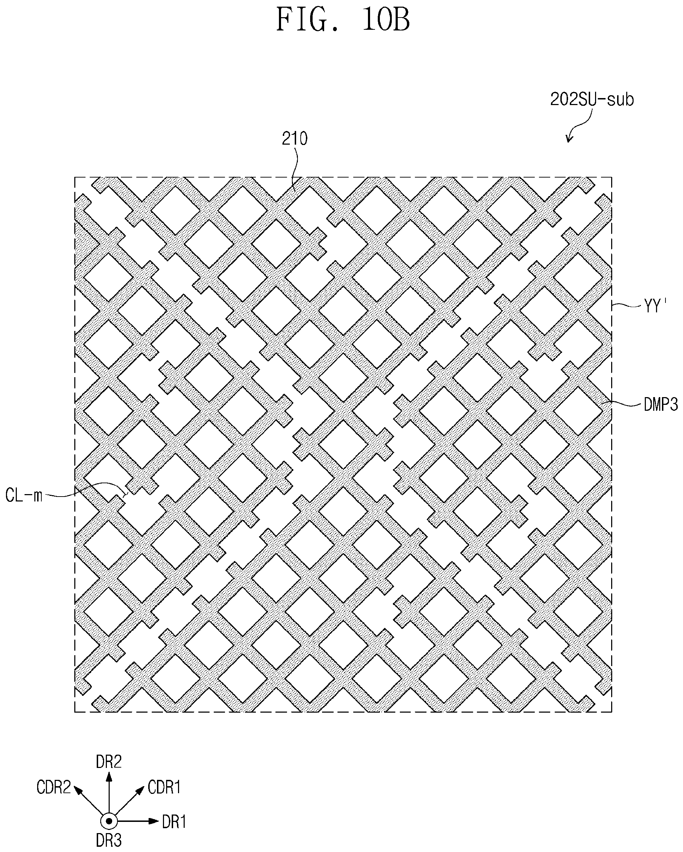

FIG. 10A is a schematic enlarged plan view of area XX' illustrated in FIG. 9D. FIG. 10B is a schematic enlarged plan view of area YY' illustrated in FIG. 9A. For example, a fourth conductive layer 208SU-sub shown in FIG. 10A is an enlarged view of the fourth conductive layer 208SU of a single sub-sensing part corresponding to the area XX' illustrated in FIG. 9D. The first conductive layer 202SU-sub shown in FIG. 10B is an enlarged view of the first conductive layer 202SU of a single sub-sensing part corresponding to the area YY' illustrated in FIG. 9A.

Referring to FIGS. 8, 9A to 9D, 10A, and 10B, the first electrodes 210, the second electrodes 220, the third electrodes 230, the fourth electrodes 240, the first dummy patterns DMP1, the second dummy patterns DMP2, and the third dummy patterns DMP3 may each have a mesh structure.

The mesh structure may include mesh lines. The mesh lines may have shapes extending in directions (e.g., predetermined or selectable directions) and may be electrically connected to one another. The shapes (e.g., the shapes of the mesh structure) may have various shapes such as a straight line, a line having protrusions, and an uneven line. Openings where a conductive layer is not disposed may be defined (or, provided or formed) in each of the first electrodes 210, the second electrodes 220, the third electrodes 230, the fourth electrodes 240, the first dummy patterns DMP1, the second dummy patterns DMP2, and the third dummy patterns DMP3.

In FIGS. 10A and 10B, the mesh structure may include mesh lines extending in a first intersecting direction (e.g., a first crossing direction) CDR1 that intersects (e.g., crosses) the first direction DR1 and the second direction DR2 and mesh lines extending in a second intersecting direction (e.g., a second crossing direction) CDR2 that intersects (e.g., crosses) the first intersecting direction (e.g., the first crossing direction) CDR1. However, the extension directions of the mesh lines constituting the mesh structure are not limited to those illustrated in FIGS. 10A and 10B. For example, the mesh structure may include only mesh lines extending in the first direction DR1 and the second direction DR2 or may include mesh lines extending in the first direction DR1, the second direction DR2, the first intersecting direction (e.g., the first crossing direction) CDR1, and the second intersecting direction (e.g., the second crossing direction) CDR2. For example, the mesh structure may be modified in various forms.

According to an embodiment of the disclosure, portions of the first conductive layer 202, the second conductive layer 204, the third conductive layer 206, and the fourth conductive layer 208 that overlap the sensing area 200A (e.g., refer to FIG. 8) illustrated in FIG. 8 in a plan view may all have a mesh structure. A magnetic field formed by the first electrodes 210 included in the first conductive layer 202 and the second electrodes 220 included in the second conductive layer 204 may be provided to the outside of the electronic device 1000 (e.g., refer to FIG. 1A) through the third conductive layer 206 and the fourth conductive layer 208. For example, since the third conductive layer 206 and the fourth conductive layer 208 have the mesh structure, the attenuation of the magnetic field by the third conductive layer 206 and the fourth conductive layer 208 may be minimized.

For example, the first to fourth conductive layers 202, 204, 206, and 208 may all have a mesh structure, and the mesh structure may include disconnection portions CL-m. The disconnection portions CL-m may refer to portions where a portion of the mesh structure is not disposed. For example, the gaps between mesh lines may be referred to as the disconnection portions CL-m. Accordingly, the possibility that an eddy current will be generated in the first to fourth conductive layers 202, 204, 206, and 208 may be reduced. Thus, the attenuation of the magnetic field by the eddy current may be decreased.

The disconnection portions CL-m provided in the fourth conductive layer 208 that is the outermost layer among the first to fourth conductive layers 202, 204, 206, and 208 may not be disposed (e.g., arranged) according to a rule (e.g., a specific or selectable rule), but may be randomly disposed (e.g., arranged). Regularity depending on the reflection of external light may be reduced, and thus the probability that the patterns will be visually recognized by the user may be reduced.

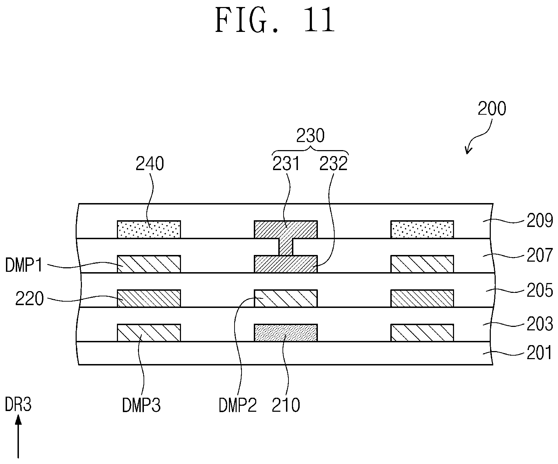

FIG. 11 is a schematic cross-sectional view of the sensor layer 200 according to an embodiment of the disclosure.

FIG. 11 illustrates a mesh line of each of the components included in the sensor layer 200 and schematically illustrates an overlapping relationship between the components. In FIG. 11, the mesh lines having a same width may be included in the four layers. However, the disclosure is not limited thereto. For example, the relationship between the widths of the mesh lines included in the four layers may be modified as described with reference to FIGS. 7A, 7B, and 7C.

Referring to FIG. 11, the first dummy pattern DMP1 may be disposed between the second electrode 220 and the fourth electrode 240. Interference of signals that is likely to occur between the second electrode 220 and the fourth electrode 240 may be minimized by the first dummy pattern DMP1. The second dummy pattern DMP2 may be disposed between the bridge pattern 232 and the first electrode 210. Interference of signals between the third electrode 230 and the first electrode 210 may be minimized by the second dummy pattern DMP2. The third dummy pattern DMP3 may face the second electrode 220.

In an embodiment of the disclosure, each of the first dummy pattern DMP1, the second dummy pattern DMP2, and the third dummy pattern DMP3 may be electrically grounded. The first dummy pattern DMP1, the second dummy pattern DMP2, and the third dummy pattern DMP3 may function as (or be implemented with) shielding electrodes. The transfer of a signal depending on an operation of the sensor layer 200 to the display layer 100 (e.g., refer to FIG. 6) may be shielded by the first dummy pattern DMP1, the second dummy pattern DMP2, and the third dummy pattern DMP3 that are grounded. In other embodiments, the transfer of a signal provided by the display layer 100 to the third electrode 230 and the fourth electrode 240 may be shielded by the first dummy pattern DMP1, the second dummy pattern DMP2, and the third dummy pattern DMP3 that are grounded.

In an embodiment of the disclosure, each of the first dummy pattern DMP1, the second dummy pattern DMP2, and the third dummy pattern DMP3 may be electrically floated. In other embodiments, at least one of the first dummy pattern DMP1, the second dummy pattern DMP2, and the third dummy pattern DMP3 may be floated, and the rest (e.g., the remaining of the first to third dummy patterns DMP1, DMP2, and DMP3) may be grounded.

In an embodiment of the disclosure, each of the first dummy pattern DMP1, the second dummy pattern DMP2, and the third dummy pattern DMP3 may be provided with an inverse signal of a signal provided to an adjacent electrode. Noise caused by signals provided from the sensor layer 200 may be cancelled out and eliminated or reduced by the inverse signal applied to each of the first to third dummy patterns DMP1, DMP2, and DMP3. For example, noises in the sensor layer 200 that are caused by the display layer 100 (e.g., refer to FIG. 6) may cancel each other out or may be eliminated. Accordingly, the display quality of the display layer 100 may be improved. In other embodiments, noise by which the electronic device 1000 (e.g., refer to FIG. 1A) affects another electronic device may be eliminated or reduced.

In an embodiment of the disclosure, each of the first dummy pattern DMP1, the second dummy pattern DMP2, and the third dummy pattern DMP3 may be driven to reduce interference with an adjacent electrode. For example, a signal (e.g., a predetermined or selectable signal) may be provided to at least one of the first dummy pattern DMP1, the second dummy pattern DMP2, and the third dummy pattern DMP3, and the rest (e.g., the remaining of the first to third dummy patterns DMP1, DMP2, and DMP3) may be grounded. In other embodiments, a signal (e.g., a predetermined or selectable signal) may be provided to the first dummy pattern DMP1, the second dummy pattern DMP2, and the third dummy pattern DMP3. Detailed description thereabout will be given below.

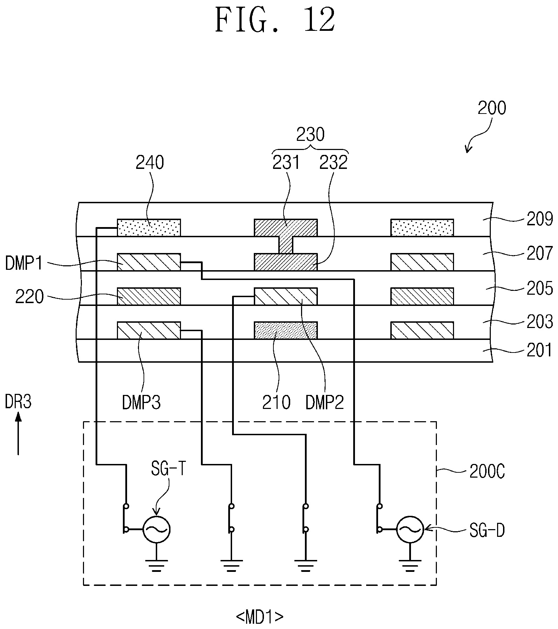

FIG. 12 is a schematic view illustrating a cross-sectional view of the sensor layer 200 and an operation of the sensor driver 200C according to an embodiment of the disclosure.

Referring to FIG. 12, the sensor driver 200C and the sensor layer 200 may operate in a first mode MD1. The first mode MD1 may include a mutual capacitance detection mode. In other embodiments, the first mode MD1 may further include a self-capacitance detection mode.

In the first mode MD1, the sensor driver 200C may detect the coordinates of a touch input using the third electrode 230 and the fourth electrode 240. For example, in the mutual capacitance detection mode, the sensor driver 200C may sense a change in the mutual capacitance between the third electrodes 230 and the fourth electrodes 240 and may calculate input coordinates (e.g., input coordinates of the touch input).

In the first mode MD1, the sensor driver 200C may detect the coordinates of the first input 2000 (e.g., refer to FIG. 5) by sequentially outputting a transmission signal SG-T to one of the third electrodes 230 and the fourth electrodes 240 and receiving a reception signal from another of the third electrodes 230 and the fourth electrodes 240.

In FIG. 12, the sensor driver 200C may output the transmission signal SG-T to the fourth electrode 240. The sensor driver 200C may output a signal SG-D to the first dummy patterns DMP1 disposed adjacent to the fourth electrode 240. The signal SG-D and the transmission signal SG-T may have a same phase. Another second dummy pattern DMP2 and another third dummy pattern DMP3 that are not adjacent to (or spaced apart from) the fourth electrode 240 may be grounded.

For example, in case that the sensor driver 200C outputs the transmission signal SG-T to the third electrode 230 in the first mode MD1, another signal (e.g., the signal SG-D) may be provided to the first dummy pattern DMP1 and the second dummy pattern DMP2 that are adjacent to the bridge pattern 232 and the pattern 231, and the third dummy pattern DMP3 may be grounded. The transmission signal SG-T and the another signal (e.g., the signal SG-D) provided to the first dummy pattern DMP1 and the second dummy pattern DMP2 that are adjacent to the bridge pattern 232 and the pattern 231 may have a same phase.

According to an embodiment of the disclosure, signals (e.g., the transmission signal SG-T and the another signal SG-D) having the same phase may be simultaneously provided to the fourth electrode 240 and the first dummy patterns DMP1 facing the fourth electrode 240. The potential difference between the fourth electrode 240 and the first dummy patterns DMP1 may be minimized or eliminated, and thus the parasitic capacitance between the fourth electrode 240 and the first dummy patterns DMP1 may be minimized or eliminated. Since the parasitic capacitance is reduced or eliminated, the RC load or RC delay of the fourth electrode 240 may be reduced, and the touch sensing performance of the sensor layer 200 may be improved.

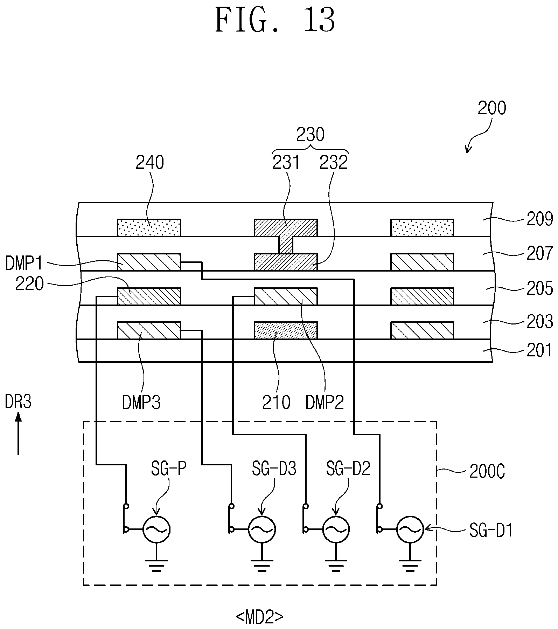

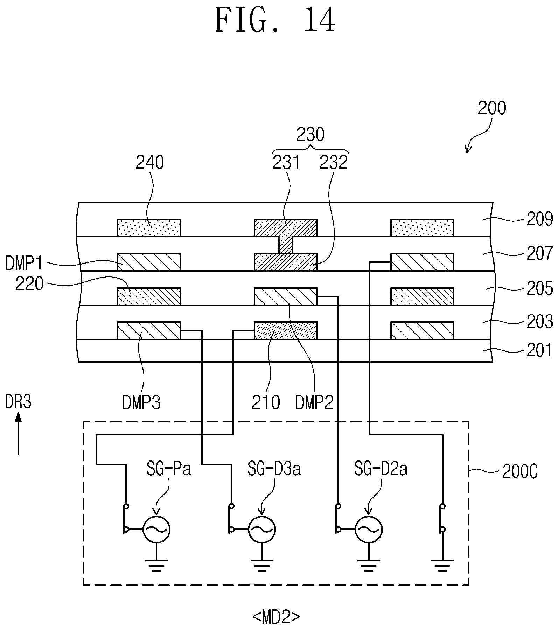

FIG. 13 is a schematic view illustrating a cross-sectional view of the sensor layer 200 and an operation of the sensor driver 200C according to an embodiment of the disclosure. FIG. 14 is a schematic view illustrating a cross-sectional view of the sensor layer 200 and an operation of the sensor driver 200C according to an embodiment of the disclosure.

Referring to FIGS. 8, 13, and 14, the sensor driver 200C and the sensor layer 200 may operate in a second mode MD2. The second mode MD2 may include a charging operation mode and a pen sensing operation mode.

In the second mode MD2, the sensor driver 200C may detect the coordinates of a pen input using the first electrodes 210 and the second electrodes 220. For example, the sensor driver 200C may generate a magnetic field using the first electrodes 210 and the second electrodes 220 and may sense an induced current by a magnetic field provided from the pen PN (e.g., refer to FIG. 5) using the first electrodes 210 and the second electrodes 220.

In the charging operation mode, the sensor driver 200C may output a signal SG-P or SG-Pa to the first electrode 210 or the second electrode 220. For example, the sensor driver 200C may provide a first signal and a second signal different from the first signal to a second loop trace line 210rt2 and another second loop trace line 210rt2 that are electrically connected to the first electrodes 210. For example, the first signal may be a sinusoidal signal or a square-wave signal, and the second signal may be an inverse signal of the first signal or a signal having a voltage (e.g., a predetermined or selectable voltage).

Since the first electrodes 210 are electrically connected to each other by the first loop trace line 210rt1 (e.g., refer to FIG. 8), a current path in the form of a coil may be defined. For example, adjacent ones of the first electrodes 210 and the first loop trace line 210rt1 electrically connected to the adjacent ones of the first electrodes 210 may form the coil. In the charging operation mode, the resonance circuit of the pen PN (e.g., refer to FIG. 5) may be charged by a magnetic field generated by the current path.

Referring to FIG. 13, the sensor driver 200C may provide the signal SG-P to the second electrode 220 in the second mode MD2. The sensor driver 200C may simultaneously output a first signal SG-D1, a second signal SG-D2, and a third signal SG-D3 to the first dummy pattern DMP1 disposed adjacent to the second electrode 220, the second dummy pattern DMP2, and the third dummy pattern DMP3, respectively. The first signal SG-D1, the second signal SG-D2, the third signal SG-D3 and the signal SG-P may have a same phase (or substantially the same phase) and a same waveform (or substantially the same waveform).

Since the signals (e.g., the first to third signals SG-D1, SG-D2, and SG-D3 and the signal SG-P) having the same phase are simultaneously provided to the second electrode 220 and the first to third dummy patterns DMP1, DMP2, and DMP3 adjacent to the second electrode 220, the potential difference between the second electrode 220 and the first to third dummy patterns DMP1, DMP2, and DMP3 adjacent to the second electrode 220 may be minimized or eliminated. Accordingly, the parasitic capacitance between the second electrode 220 and the first to third dummy patterns DMP1, DMP2, and DMP3 may be minimized or eliminated. Since the parasitic capacitance is reduced or eliminated, the RC load or RC delay of the second electrode 220 may be reduced, and the pen charging performance and the pen sensing performance of the sensor layer 200 may be improved.

Referring to FIG. 14, the sensor driver 200C may provide the signal SG-Pa to the first electrode 210 in the second mode MD2. The sensor driver 200C may simultaneously output a second signal SG-D2a and a third signal SG-D3a to the second dummy pattern DMP2 disposed adjacent to the first electrode 210 and the third dummy pattern DMP3, respectively. The second signal SG-D2a, the third signal SG-D3a, and the signal SG-Pa may have a same phase (or substantially the same phase) and a same waveform (or substantially the same waveform). Another first dummy pattern DMP1 that is not adjacent to (or is spaced apart from) the first electrode 210 may be grounded.

Since the signals (e.g., the second signal SG-D2a, the third signal SG-D3a, and the signal SG-Pa) having the same phase are simultaneously provided to the first electrode 210 and the second and third dummy patterns DMP2 and DMP3 adjacent to the first electrode 210, the potential difference between the first electrode 210 and the second and third dummy patterns DMP2 and DMP3 may be minimized or eliminated. Accordingly, the parasitic capacitance between the first electrode 210 and the second and third dummy patterns DMP2 and DMP3 may be minimized or eliminated. Since the parasitic capacitance is reduced or eliminated, the RC load or RC delay of the first electrode 210 may be reduced, and the pen charging performance and the pen sensing performance of the sensor layer 200 may be improved.

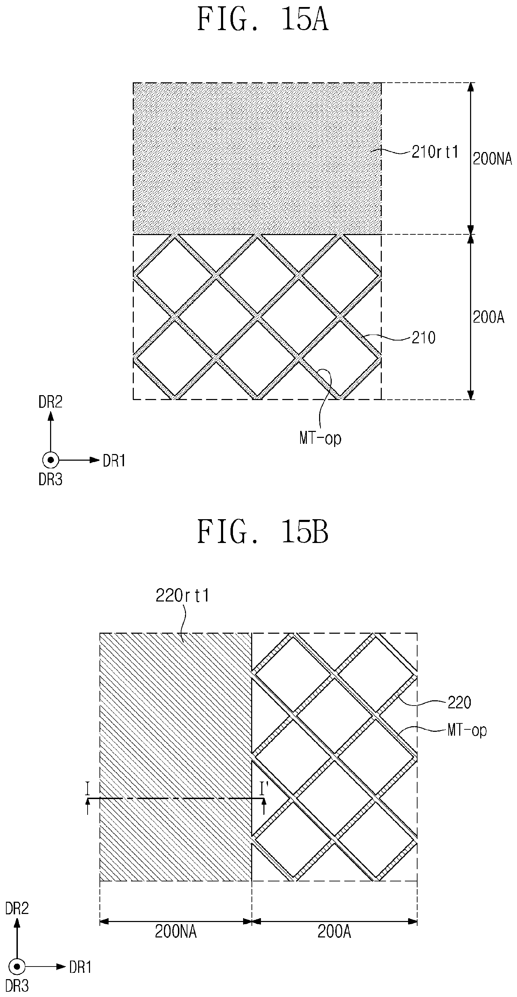

FIG. 15A is a schematic plan view illustrating a portion of the first conductive layer 202 (e.g., refer to FIG. 6) according to an embodiment of the disclosure. FIG. 15B is a schematic plan view illustrating a portion of the second conductive layer 204 (e.g., refer to FIG. 6) according to an embodiment of the disclosure.

Referring to FIGS. 15A and 15B, a portion of the first electrode 210 and a portion of the second electrode 220 may be disposed in the sensing area 200A, and a portion of the first loop trace line 210rt1 and a portion of the third loop trace line 220rt1 may be disposed in the peripheral area 200NA. The first loop trace line 210rt1 may be electrically connected to the first electrode 210, and the third loop trace line 220rt1 may be electrically connected to the second electrode 220.

According to an embodiment of the disclosure, each of the first electrode 210 and the second electrode 220 may have a mesh structure in which openings MT-op are defined, and each of the first loop trace line 210rt1 and the third loop trace line 220rt1 may have a solid structure in which an opening is not defined. For example, the sensor layer 200 may include the first loop trace line 210rt1 without an opening and the third loop trace line 220rt1 without an opening. Each of the third loop trace line 220rt1, the fourth loop trace lines 220rt2, the first trace lines 230t (e.g., refer to FIG. 8), and the second trace lines 240t (e.g., refer to FIG. 8) may also have a solid structure in which an opening is not defined. For example, the sensor layer 200 may include the third loop trace line 220rt1 without an opening, the fourth loop trace lines 220rt2 without an opening, the first trace lines 230t without any opening, and the second trace lines 240t without any opening. However, this is only an example, and at least some of the trace lines may have a mesh structure in which openings are defined.

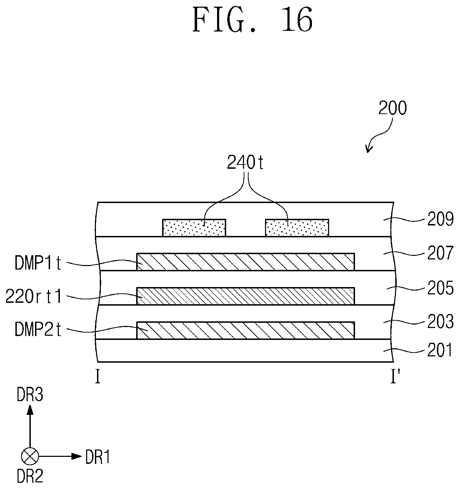

FIG. 16 is a schematic cross-sectional view of the sensor layer 200 according to an embodiment of the disclosure. For example, FIG. 16 is a schematic cross-sectional view of the sensor layer 200 including a portion taken along line I-I' illustrated in FIG. 15B.

Referring to FIGS. 8 and 16, the sensor layer 200 may further include a first dummy trace pattern DMP1t and a second dummy trace pattern DMP2t. For example, the first dummy trace pattern DMP1t may be disposed between the third loop trace line 220rt1 and the second trace lines 240t. The second dummy trace pattern DMP2t may be spaced apart from the first dummy trace pattern DMP1t with the third loop trace line 220rt1 therebetween. For example, the third loop trace line 220rt1 may be disposed between the second dummy trace pattern DMP2t and the first dummy trace pattern DMP1t.

Interference between the third loop trace line 220rt1 and the second trace lines 240t may be minimized by the first dummy trace pattern DMP1t. In an embodiment of the disclosure, the second dummy trace pattern DMP2t may be omitted.

Each of the first dummy trace pattern DMP1t and the second dummy trace pattern DMP2t may be electrically floated. In other embodiments, each of the first dummy trace pattern DMP1t and the second dummy trace pattern DMP2t may be electrically grounded. The first dummy trace pattern DMP1t and the second dummy trace pattern DMP2t may function as (be implemented with) shielding electrodes. In another embodiment, at least one of the first dummy trace pattern DMP1t and the second dummy trace pattern DMP2t may be floated, and the rest (e.g., the remaining of the first and second dummy trace patterns DMP1t and DMP2t) may be grounded. In yet another embodiment, at least one of the first dummy trace pattern DMP1t and the second dummy trace pattern DMP2t may be provided with a signal that is the same as a signal provided to an adjacent line.

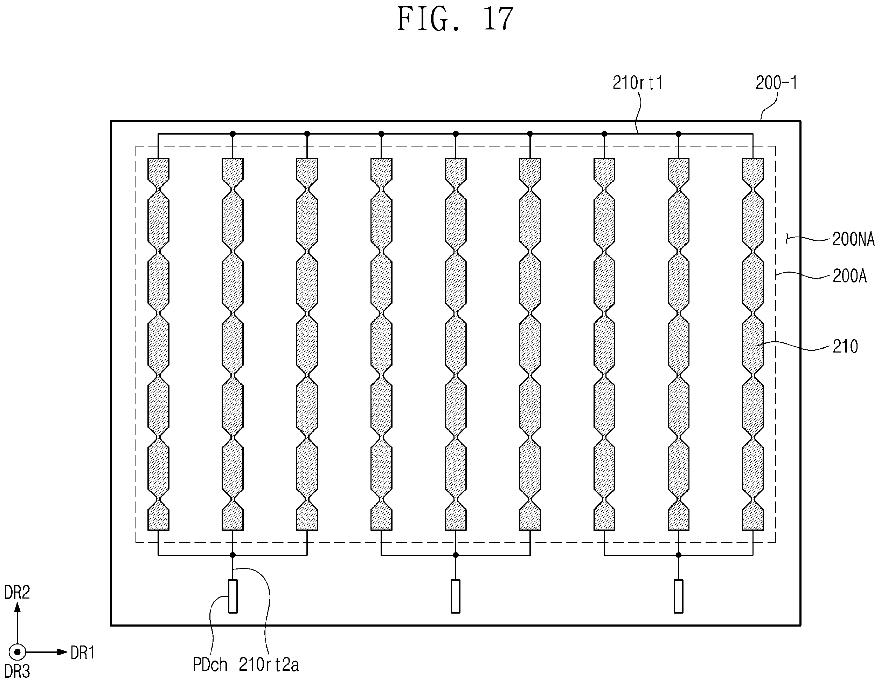

FIG. 17 is a schematic plan view illustrating some components of a sensor layer 200-1 according to an embodiment of the disclosure.

Referring to FIG. 17, the sensor layer 200-1 may include first electrodes 210, a first loop trace line 210rt1, and second loop trace lines 210rt2a. The first electrodes 210 may be disposed in a sensing area 200A, and the first loop trace line 210rt1 and the second loop trace lines 210rt2a may be disposed in a peripheral area 200NA.

In an embodiment of the disclosure, each second loop trace line 210rt2a may be electrically connected to two or more first electrodes 210. Accordingly, each pad PDch electrically connected to the second loop trace line 210rt2a may be electrically connected to the two or more first electrodes 210.

In FIG. 17, each second loop trace line 210rt2a may be electrically connected to three first electrodes 210. However, the disclosure is not limited thereto. For example, each second loop trace line 210rt2a may be electrically connected to two first electrodes 210 or may be electrically connected to four or more first electrodes 210.

First electrodes 210 electrically connected to each second loop trace line 210rt2a may be referred to as an electrode group. As the number of first electrodes 210 included in the electrode group and electrically connected in parallel is increased, the resistance of the electrode group may be lowered, and thus power efficiency and pen charging sensitivity may be improved.

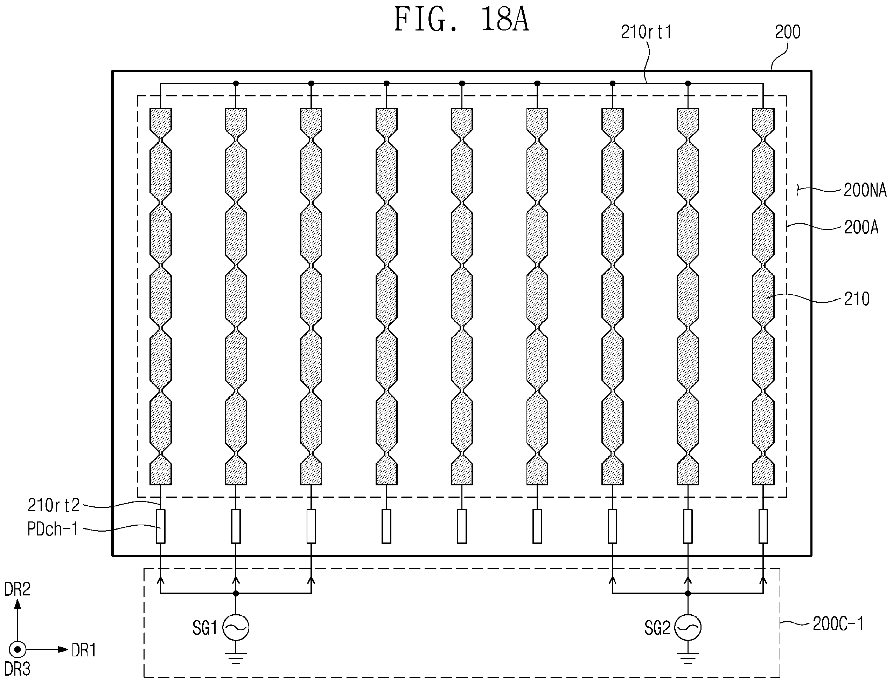

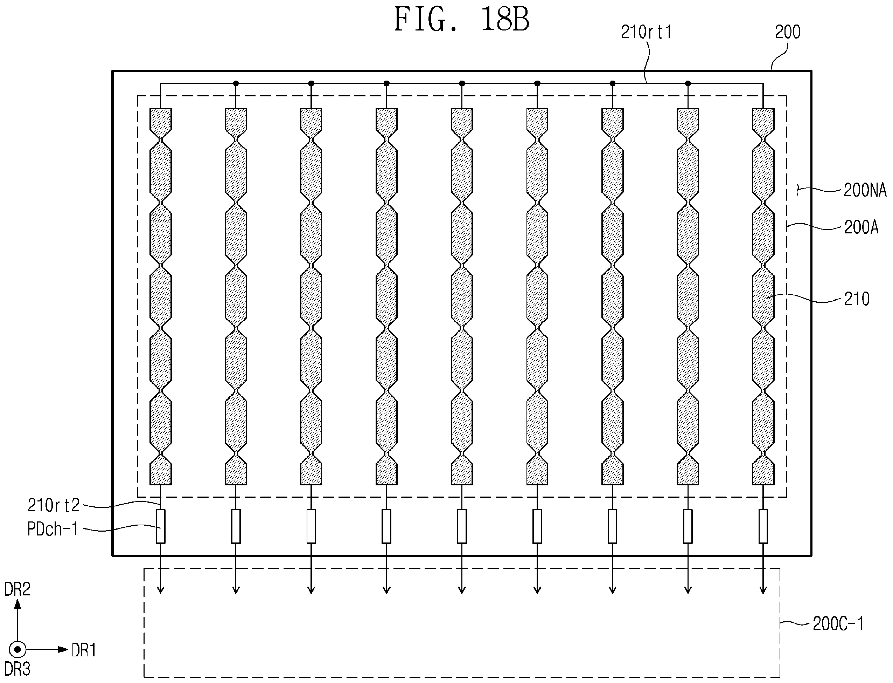

FIG. 18A is a schematic view illustrating some components of the sensor layer 200 and an operation of a sensor driver 200C-1 according to an embodiment of the disclosure. FIG. 18B is a schematic view illustrating some components of the sensor layer 200 and an operation of the sensor driver 200C-1 according to an embodiment of the disclosure.

Referring to FIGS. 18A and 18B, the sensor layer 200 may include the first electrodes 210, the first loop trace line 210rt1, and the second loop trace lines 210rt2. The first electrodes 210 may be disposed in the sensing area 200A, and the first loop trace line 210rt1 and the second loop trace lines 210rt2 may be disposed in the peripheral area 200NA. The first electrodes 210 may be electrically connected to the second loop trace lines 210rt2 in a one-to-one correspondence. For example, the first electrodes 210 may be electrically connected to the second loop trace lines 210rt2, respectively.

According to an embodiment of the disclosure, depending on the operation modes, pads PDch-1 electrically connected to the second loop trace lines 210rt2 in a one-to-one correspondence may operate in a form in which at least some of the pads PDch-1 are electrically connected to one another or may operate in a form in which the pads PDch-1 are electrically isolated from one another.

Referring to FIG. 18A, in the charging operation mode, the sensor driver 200C-1 may provide a first signal SG1 to one or more first electrodes 210 among the first electrodes 210 and may provide a second signal SG2 to one or more other first electrodes 210 among the first electrodes 210. The first signal SG1 may have an inverse phase relationship with the second signal SG2.

Since the first electrodes 210 are electrically connected to one another by the first loop trace line 210rt1, a current path in the form of a coil that includes the first electrodes 210 to which the first signal SG1 is provided and the first electrodes 210 to which the second signal SG2 is provided may be defined. For example, adjacent ones of the first electrodes 210 and the first loop trace line 210rt1 electrically connected to the adjacent ones of the first electrodes 210 may form the coil. In the charging operation mode, the resonance circuit of the pen PN (e.g., refer to FIG. 5) may be charged by a magnetic field generated by the current path.

According to an embodiment of the disclosure, the number of first electrodes 210 to which the first signal SG1 or the second signal SG2 is provided may be one or more. In FIG. 18A, in the charging operation mode, three pads PDch-1 (e.g., three pads PDch-1 of the pads PDch-1) may receive the first signal SG1 and three pads PDch-1 (e.g., another three pads PDch-1 of the pads PDch-1) may receive the second signal SG2. For example, in the charging operation mode, one or more pads PDch-1 disposed (e.g., arranged) in succession (e.g., one or more adjacent pads PDch-1) may operate in a form in which the pads PDch-1 are electrically connected together. Accordingly, according to an embodiment of the disclosure, the resistance of the current path may be reduced, and thus power efficiency and pen charging sensitivity may be improved.

Referring to FIG. 18B, in the pen sensing operation mode, the sensor driver 200C-1 may receive an induced current from each of the second loop trace lines 210rt2. In the pen sensing operation mode, the pads PDch-1 may be electrically isolated from one another and may output signals, respectively. Accordingly, the pen detection coordinate accuracy of the sensor layer 200 may be further improved.

As described above, not only the touch input but also the pen input may be sensed using the sensor layer. For example, the sensor layer may sense the touch input and the pen input. Accordingly, a separate component (e.g., a digitizer) that senses the pen does not need to be added to the electronic device, and thus an increase in the thickness and weight of the electronic device and a decrease in the flexibility of the electronic device depending on the addition of the digitizer may not occur. For example, the thickness and weight of the electronic device may be decreased, and the flexibility of the electronic device may be increased by the omission of the digitizer.

For example, the sensor layer may include the first to fourth conductive layers sequentially stacked one above another, and the portions of the first to fourth conductive layers that overlap the sensing area in a plan view may all have the mesh structure. The magnetic field generated by the electrodes included in the first conductive layer and the second conductive layer may be provided to the outside through the openings of the third conductive layer and the fourth conductive layer. The attenuation of the magnetic field may be minimized because the first to fourth conductive layers have the mesh structure. The possibility that an eddy current will be generated may be decreased by the mesh structure and the disconnection portions provided in the mesh structure. Thus, the attenuation of the magnetic field by the eddy current may be reduced or eliminated. For example, the eddy current may be prevented, and sensing accuracy of the electronic device may be improved.

Moreover, each of the first to third conductive layers of the sensor layer may include the dummy patterns. Since the wiring density difference between the layers is decreased by the dummy patterns, a deviation depending on the reflection of external light may be decreased, and thus the probability that the patterns will be visually recognized by the user may be reduced. Depending on the operations of the sensor layer, the dummy patterns may be grounded, or another signal having the same phase as a signal provided to an adjacent electrode may be provided to the dummy patterns. Accordingly, interference of signals in the sensor layer may be minimized, or the RC load or RC delay of each electrode in the sensor layer may be reduced. Thus, the touch sensing performance, the pen sensing performance, and the sensing accuracy may be improved.

Embodiments are set out in the following clauses:
Clause 1. An electronic device comprising: a first conductive layer including a first electrode having a first mesh structure; a second conductive layer disposed over the first conductive layer, the second conductive layer including a second electrode having a second mesh structure; a third conductive layer disposed over the second conductive layer, the third conductive layer including a plurality of bridge patterns having a third mesh structure; and a fourth conductive layer disposed over the third conductive layer, the fourth conductive layer including a plurality of patterns having a fourth mesh structure and electrically connected to the plurality of bridge patterns, wherein the third conductive layer further includes a first dummy pattern disposed over the second electrode.
Clause 2. The electronic device of Clause 1, wherein the plurality of bridge patterns and the plurality of patterns are included in a third electrode, and the fourth conductive layer further includes a fourth electrode electrically insulated from the third electrode and intersecting the third electrode.
Clause 3. The electronic device of Clause 2, wherein the first dummy pattern is disposed between the second electrode and the fourth electrode.
Clause 4. The electronic device of Clause 2 or 3, wherein the second conductive layer further includes a second dummy pattern disposed between the first electrode and the plurality of bridge patterns.
Clause 5. The electronic device of Clause 4, wherein the first conductive layer further includes a third dummy pattern, and the third dummy pattern overlaps at least one of the second electrode, the plurality of bridge patterns, the plurality of patterns, and the fourth electrode in a plan view.
Clause 6. The electronic device of Clause 5, wherein in case that a signal is provided to at least one of the third electrode and the fourth electrode, another signal is provided to the first dummy pattern, the signal provided to the at least one of the third electrode and the fourth electrode and the another signal provided to the first dummy pattern have a same phase, and the second dummy pattern and the third dummy pattern are grounded.
Clause 7. The electronic device of Clause 5 or 6, wherein in case that a signal is provided to the second electrode, another signal is provided to each of the first dummy pattern, the second dummy pattern, and the third dummy pattern, and the signal provided to the second electrode and the another signal provided to each of the first dummy pattern, the second dummy pattern, and the third dummy pattern have a same phase.
Clause 8. The electronic device of Clause 5, 6 or 7, wherein in case that a signal is provided to the first electrode, another signal is provided to each of the second dummy pattern and the third dummy pattern, the signal provided to the first electrode and the another signal provided to each of the second dummy pattern and the third dummy pattern have a same phase, and the first dummy pattern is grounded.
Clause 9. The electronic device of any of Clause 2 to 8, wherein the third electrode includes a plurality of first split electrodes spaced apart from one another in a first direction, the fourth electrode includes a plurality of second split electrodes spaced apart from one another in a second direction intersecting the first direction, and each of the plurality of first split electrodes includes each of the plurality of bridge patterns and each of the plurality of patterns.
Clause 10. The electronic device of Clause 9, wherein the first electrode overlaps a first split electrode among the plurality of first split electrodes in a plan view, and the second electrode overlaps a second split electrode among the plurality of second split electrodes in a plan view.
Clause 11. The electronic device of Clause 10, wherein the second conductive layer further includes a plurality of second dummy patterns, the plurality of second dummy patterns do not overlap the second split electrode among the plurality of second split electrodes, which overlaps the second electrode, and overlap other second split electrodes among the plurality of second split electrodes in a plan view, the first conductive layer further includes a plurality of third dummy patterns, and the plurality of third dummy patterns do not overlap the first split electrode among the plurality of first split electrodes, which overlaps the first electrode, and overlap other first split electrodes among the plurality of first split electrodes in a plan view.
Clause 12. The electronic device of any preceding Clause, wherein the first mesh structure includes a first mesh line having a first width, the second mesh structure includes a second mesh line having a second width, the third mesh structure includes a third mesh line having a third width, and the fourth mesh structure includes a fourth mesh line having a fourth width.
Clause 13. The electronic device of Clause 12, wherein the fourth width is greater than the third width, and the third width is greater than or equal to the second width and the first width.
Clause 14. The electronic device of Clause 12, wherein the fourth width is greater than the third width, the third width is greater than the second width, and the second width is greater than the first width.
Clause 15. The electronic device of any of Clauses 2 to 14, further comprising: a sensor driver electrically connected to the third electrode, the fourth electrode, the first electrode, and the second electrode, wherein the sensor driver is configured to selectively operate in at least one of a first mode to sense a touch input and a second mode to sense a pen input, the sensor driver is configured to detect coordinates of the touch input using the third electrode and the fourth electrode in the first mode, and the sensor driver is configured to detect coordinates of the pen input using the first electrode and the second electrode in the second mode.
Clause 16. The electronic device of any preceding Clause, wherein the first electrode includes a plurality of first electrodes, the first conductive layer further includes: a first loop trace line electrically connected to first ends of the plurality of first electrodes; and a second loop trace line electrically connected to at least one of the plurality of first electrodes, and the first loop trace line and the second loop trace line have a solid structure without an opening.
Clause 17. The electronic device of any preceding Clause, further comprising: a display layer disposed under the first conductive layer and configured to display an image in a direction toward the first conductive layer, wherein the first conductive layer, the second conductive layer, the third conductive layer, and the fourth conductive layer are sequentially stacked in a direction away from the display layer.

The above description is an example of technical features of the disclosure, and those skilled in the art to which the disclosure pertains will be able to make various modifications and variations. Thus, the embodiments of the disclosure described above may be implemented separately or in combination with each other.

Therefore, the embodiments disclosed in the disclosure are not intended to limit the technical scope of the disclosure. The protection scope of the disclosure should be interpreted by the following claims.

## Claims

1. An electronic device (1000) comprising:
a first conductive layer (202) including a first electrode (210) having a first mesh structure;
a second conductive layer (204) disposed over the first conductive layer (202), the second conductive layer (204) including a second electrode (220) having a second mesh structure;
a third conductive layer (206) disposed over the second conductive layer (204), the third conductive layer (206) including a plurality of bridge patterns (232) having a third mesh structure; and
a fourth conductive layer (208) disposed over the third conductive layer (206), the fourth conductive layer (208) including a plurality of patterns (231) having a fourth mesh structure and electrically connected to the plurality of bridge patterns (232),
wherein the third conductive layer (206) further includes a first dummy pattern (DMP1) disposed over the second electrode (220).

2. The electronic device of claim 1, wherein
the plurality of bridge patterns (232) and the plurality of patterns (231) are included in a third electrode (230), and
the fourth conductive layer (208) further includes a fourth electrode (240) electrically insulated from the third electrode (230) and intersecting the third electrode (230).

3. The electronic device of claim 2, wherein the first dummy pattern (DMP1) is disposed between the second electrode (220) and the fourth electrode (240).

4. The electronic device of claim 2 or 3, wherein the second conductive layer (204) further includes a second dummy pattern (DMP2) disposed between the first electrode (210) and the plurality of bridge patterns (232).

5. The electronic device of claim 4, wherein
the first conductive layer (202) further includes a third dummy pattern (DMP3), and
the third dummy pattern (DMP3) overlaps at least one of the second electrode (220), the plurality of bridge patterns (232), the plurality of patterns (231), and the fourth electrode (240) in a plan view.

6. The electronic device of claim 5, wherein
in case that a signal (SG-T) is provided to at least one of the third electrode (230) and the fourth electrode (240), another signal (SG-D) is provided to the first dummy pattern,
the signal (SG-T) provided to the at least one of the third electrode (230) and the fourth electrode (240) and the another signal (SG-D) provided to the first dummy pattern (DMP1) have a same phase, and
the second dummy pattern (DMP2) and the third dummy pattern (DMP3) are grounded; and /or
in case that a signal (SG-P) is provided to the second electrode (220), another signal (SG-D1, SG-D2, SG-D3) is provided to each of the first dummy pattern (DMP1), the second dummy pattern (DMP2), and the third dummy pattern (DMP3), and
the signal (SG-P) provided to the second electrode (220) and the another signal (SG-D1, SG-D2, SG-D3) provided to each of the first dummy pattern (DMP1), the second dummy pattern (DMP2), and the third dummy pattern (DMP3) have a same phase; and/or
in case that a signal (SG-Pa) is provided to the first electrode (210), another signal (SG-D2a, SG-D3a) is provided to each of the second dummy pattern (DMP2) and the third dummy pattern (DMP3),
the signal (SG-Pa) provided to the first electrode (210) and the another signal (SG-D2a, SG-D3a) provided to each of the second dummy pattern (DMP2) and the third dummy pattern (DMP3) have a same phase, and
the first dummy pattern (DMP1) is grounded.

7. The electronic device of any of claims 2 to 6, wherein
the third electrode (230) includes a plurality of first split electrodes (230-dv) spaced apart from one another in a first direction (DR1),
the fourth electrode (240) includes a plurality of second split electrodes (240-dv) spaced apart from one another in a second direction (DR2) intersecting the first direction (DR1), and
each of the plurality of first split electrodes (230-dv) includes each of the plurality of bridge patterns (232) and each of the plurality of patterns (231).

8. The electronic device of claim 7, wherein
the first electrode (210) overlaps a first split electrode (230-dv) among the plurality of first split electrodes (230dv) in a plan view, and
the second electrode (220) overlaps a second split electrode (240-dv) among the plurality of second split electrodes (240-dv) in a plan view.

9. The electronic device of claim 8, wherein
the second conductive layer (204) further includes a plurality of second dummy patterns (DMP2),
the plurality of second dummy patterns (DMP2) do not overlap the second split electrode (240-dv) among the plurality of second split electrodes (240-dv), which overlaps the second electrode (220), and overlap other second split electrodes (240-dv) among the plurality of second split electrodes (240-dv) in a plan view,
the first conductive layer (202) further includes a plurality of third dummy patterns (DMP3), and
the plurality of third dummy patterns (DMP3) do not overlap the first split electrode (230-dv) among the plurality of first split electrodes (230-dv), which overlaps the first electrode (210), and overlap other first split electrodes (230-dv) among the plurality of first split electrodes (230-dv) in a plan view.

10. The electronic device of any preceding claim, wherein
the first mesh structure includes a first mesh line (MS1;MS1a) having a first width (WT1;WT1a),
the second mesh structure includes a second mesh line (MS2;MS2a) having a second width (WT1;WT2a),
the third mesh structure includes a third mesh line (MS3;MS3a) having a third width (WT1;WT3a), and
the fourth mesh structure includes a fourth mesh line (MS4;MS4a) having a fourth width (WT2;WT4a).

11. The electronic device of claim 10, wherein
the fourth width (WT2;WT4a) is greater than the third width (WT1;WT3a), and
the third width (WT1;WT3a) is greater than or equal to the second width (WT1;WT2a) and the first width (WT1;WT1a).

12. The electronic device of claim 10, wherein
the fourth width (WT4a) is greater than the third width (WT3a),
the third width (WT3a) is greater than the second width (WT2a), and
the second width (WT2a) is greater than the first width (WT1a).

13. The electronic device of any of claims 2 to 12, further comprising:
a sensor driver (200C) electrically connected to the third electrode (230), the fourth electrode (240), the first electrode (210), and the second electrode (220),
wherein
the sensor driver (200C) is configured to selectively operate in at least one of a first mode (MD1) to sense a touch input (2000) and a second mode (MD2) to sense a pen (PN) input (3000),
the sensor driver (200C) is configured to detect coordinates of the touch input (2000) using the third electrode (230) and the fourth electrode (240) in the first mode (MD1), and
the sensor driver (200C) is configured to detect coordinates of the pen (PN) input (3000) using the first electrode (210) and the second electrode (220) in the second mode (MD2).

14. The electronic device of any preceding claim, wherein
the first electrode (210) includes a plurality of first electrodes,
the first conductive layer (202) further includes:
a first loop trace line (210rt1) electrically connected to first ends of the plurality of first electrodes; and
a second loop trace line (210rt2) electrically connected to at least one of the plurality of first electrodes, and
the first loop trace line (210rt1) and the second loop trace line (210rt2) have a solid structure without an opening.

15. The electronic device of any preceding claim, further comprising:
a display layer (100) disposed under the first conductive layer (202) and configured to display an image in a direction toward the first conductive layer (202),
wherein the first conductive layer (202), the second conductive layer (204), the third conductive layer (206), and the fourth conductive layer (208) are sequentially stacked in a direction away from the display layer (100).
